# EUROPEAN PATENT SPECIFICATION

(11) **EP 4 213 470 B1**
(45) Date of publication and mention of the grant of the patent: **01.01.2025**
(21) Application number: 21919857.9
(22) Date of filing: 15.11.2021
(51) Int. Cl.: H04M 1/02, F16C 11/04, G06F 1/16

(54) **HINGE STRUCTURE HAVING CENTER BAR, AND FOLDABLE ELECTRONIC DEVICE COMPRISING SAME**
SCHARNIERSTRUKTUR MIT MITTELSTANGE UND FALTBARE ELEKTRONISCHE VORRICHTUNG DAMIT
STRUCTURE DE CHARNIÈRE AYANT UNE BARRE CENTRALE, ET DISPOSITIF ÉLECTRONIQUE PLIABLE LA COMPRENANT

(30) Priority: 12.01.2021 KR 20210004251
(43) Date of publication of application: 19.07.2023
(73) Proprietor: Samsung Electronics Co., Ltd., Suwon-si, Gyeonggi-do 16677 (KR)
(72) Inventor: PARK, Daehyeong, Suwon-si, Gyeonggi-do 16677 (KR)
(74) Representative: Nederlandsch Octrooibureau
(86) International application number: PCT/KR2021/016655
(87) International publication number: WO 2022/154233

(56) References cited:
- CN-A- 110 985 524
- CN-A- 111 692 196
- CN-U- 209 731 335
- CN-U- 210 919 786
- KR-A- 20190 084 836
- KR-A- 20190 097 898
- KR-A- 20200 126 524

## Description

### [Technical Field]

Various embodiments of the disclosure relate to a hinge structure having a center bar.

### [Background Art]

A portable electronic device, such as a smartphone, may provide various functions, such as voice communication, playback of videos, and search through the internet, based on various kinds of applications. The user may intend to use the above-mentioned functions through a wider screen. However, as the screen becomes larger, portability may deteriorate. Accordingly, a foldable portable electronic device that may increase portability by utilizing a folded structure has been developed.

In the foldable electronic device, adjacent housings and a hinge structure are connected to each other, and the housings are rotated at specific angles while the hinge structure supports the housings. Patent document CN 210919786 U, published on 3 July 2020, discloses a flexible screen rotating structure and a flexible screen. The flexible screen rotating structure comprises two rotating shafts, two screen connecting assemblies and a rotating linkage assembly. Patent document KR 10-2019-0097898 A, published on 21 August 2019, discloses a electronic device including folding hinge structure. Patent document KR 10-2020-0126524 A, published on 9 November 2020, discloses a hinge structure including a first rotary bracket that rotates about a first virtual axis and a second rotary bracket that rotates about a second virtual axis. The hinge structure also includes a fixed bracket that includes the first rotary bracket and the second rotary bracket fixed thereto.

### [Disclosure]

### [Technical Problem]

The foldable electronic device may include a display, at least a portion of which is folded, and a hinge structure related to a folding or closing operation. Here, because a folded part of the display may contact a hinge structure while the foldable electronic device is folded or unfolded, a suitable structure for avoiding the contact or reducing the contact may be necessary. Furthermore, a measure for improving flatness in the unfolded state of the display is required.

Various embodiments of the disclosure provide a hinge structure having a center bar that may improve a flatness of a display of a foldable electronic device, and a foldable electronic device including the same.

Various embodiments also provide a hinge structure having a center bar that may stably maintain a location of a center bar employed in the hinge structure, and a foldable electronic device including the same.

### [Technical Solution]

The invention is set out in the appended set of claims.

### [Advantageous Effects]

According to the hinge structure including the center bar and the foldable electronic device including the same according to various embodiments, a flatness of the display may be maintained when the display is in the unfolded state and damage to the display due to stabbing may be prevented.

In addition, according to the hinge structure and the foldable electronic device including the same according to an embodiment, because a location of the center bar is stably maintained in a folding or closing operation, noise due to collision of the center bar and peripheral structure may be restrained and defects of the structure due to application of the center bar may be reduced.

Other various purposes and effects provided by the hinge structure and the foldable electronic device including the same according to various embodiments may be mentioned according to the embodiments of the detailed description.

### [Description of Drawings]

FIG. 1A is a view illustrating an exploded perspective view of an electronic device according to various embodiments.
FIG. 1B is a view illustrating an example of a rear surface of an electronic device according to various embodiments.
FIG. 1C is a view illustrating an example of a folded state of an electronic device according to various embodiments.
FIG. 2 is a view illustrating an example of a front surface and a rear surface of a hinge structure having a center bar according to various embodiments.
FIG. 3 is a view illustrating a surface of a hinge structure in a first direction of an exploded perspective view according to various embodiments.
FIG. 4 is a view illustrating a surface of a hinge structure in a second direction of an exploded perspective view according to various embodiments.
FIG. 5 is a view illustrating an example of a rotation part according to an embodiment.
FIG. 6 is a view illustrating an example of a fixing bracket according to an embodiment.
FIG. 7 is a view illustrating an example of an arm part according to an embodiment.
FIG. 8 is a view illustrating an example of the support rings according to various embodiments.
FIG. 9 is a view illustrating an example of a center bar according to various embodiments.
FIG. 10 is a view illustrating an example of a center bracket according to various embodiments.
FIG. 11 is a view illustrating an example of a fixing ring according to various embodiments.
FIG. 12 is a view illustrating an example of a first cam member according to various embodiments.
FIG. 13 is a view illustrating an example of a second cam member or a third cam member according to various embodiments.
FIG. 14 is a view illustrating a first state of some configurations of an electronic device according to various embodiments.
FIG. 15 is a view illustrating a first angle state of some structures of an electronic device according to various embodiments.
FIG. 16 is a view illustrating the second angle state of some structures of an electronic device according to various embodiments.
FIG. 17 is a view illustrating the second state of some structures of an electronic device according to various embodiments.
FIG. 18 is a view illustrating an example of another form of a center bar according to various embodiments.
FIG. 19 is a view illustrating an example of another form of an electronic device according to various embodiments.
FIG. 20 is a view illustrating an example of another form of an electronic device according to various embodiments.
FIG. 21A is a view illustrating another example of a shape of a cam according to various embodiments.
FIG. 21B is a view illustrating an example of a contact state of some mountains from a cam and a cam structure according to various embodiments.

### [Mode for Invention]

Hereinafter, various embodiments of the disclosure will be described with reference to the accompanying drawings. With regard to the description of drawings, similar components may be denoted by similar reference numerals.

In the disclosure disclosed herein, the expressions "have", "may have", "include" and "comprise", or "may include" and "may comprise" used herein indicate existence of corresponding features (e.g., components such as numeric values, functions, operations, or components) but do not exclude presence of additional features.

In the disclosure disclosed herein, the expressions "A or B", "at least one of A or/and B", or "one or more of A or/and B", and the like used herein may include any and all combinations of one or more of the associated listed items. For example, the term "A or B", "at least one of A and B", or "at least one of A or B" may refer to all of the case (1) where at least one A is included, the case (2) where at least one B is included, or the case (3) where both of at least one A and at least one B are included.

The terms, such as "first", "second", and the like used herein may refer to various components of various embodiments of the disclosure, but do not limit the components. For example, such terms are used only to distinguish a component from another component and do not limit the order and/or priority of the components. For example, a first user device and a second user device may represent different user devices irrespective of sequence or importance. For example, without departing the scope of the disclosure, a first component may be referred to as a second component, and similarly, a second component may be referred to as a first component.

It will be understood that when a component (e.g., a first component) is referred to as being "(operatively or communicatively) coupled with/to" or "connected to" another component (e.g., a second component), it can be directly coupled with/to or connected to the other component or an intervening component (e.g., a third component) may be present. In contrast, when a component (e.g., a first component) is referred to as being "directly coupled with/to" or "directly connected to" another component (e.g., a second component), it should be understood that there are no intervening component (e.g., a third component).

According to the situation, the expression "configured to" used herein may be used as, for example, the expression "suitable for", "having the capacity to", "designed to", "adapted to", "made to", or "capable of'. The term "configured to (or set to)" must not mean only "specifically designed to" in hardware. Instead, the expression "a device configured to" may mean that the device is "capable of" operating together with another device or other components. CPU, for example, a "processor configured to perform A, B, and C" may mean a dedicated processor (e.g., an embedded processor) for performing a corresponding operation or a generic-purpose processor (e.g., a central processing unit (CPU) or an application processor) which may perform corresponding operations by executing one or more software programs which are stored in a memory device.

Terms used in this specification are used to describe specified embodiments of the disclosure and are not intended to limit the scope of the disclosure. The terms of a singular form may include plural forms unless otherwise specified. Unless otherwise defined herein, all the terms used herein, which include technical or scientific terms, may have the same meaning that is generally understood by a person skilled in the art. It will be further understood that terms, which are defined in a dictionary and commonly used, should also be interpreted as is customary in the relevant related art and not in an idealized or overly formal detect unless expressly so defined herein in various embodiments of the disclosure. According to occasions, even a term defined in the disclosure cannot be construed to exclude the embodiments of the disclosure.

An electronic device according to various embodiments of the disclosure may include at least one of smartphones, tablet personal computers (PCs), mobile phones, video telephones, electronic book readers, desktop PCs, laptop PCs, netbook computers, workstations, servers, personal digital assistants (PDAs), portable multimedia players (PMPs), MP3 players, mobile medical devices, cameras, and wearable devices. According to various embodiments of the disclosure, the wearable devices may include accessories (e.g., watches, rings, bracelets, ankle bracelets, glasses, contact lenses, or head-mounted devices (HMDs)), cloth-integrated types (e.g., electronic clothes), body-attached types (e.g., skin pads or tattoos), or implantable types (e.g., implantable circuits).

Hereinafter, electronic devices according to an embodiment of the disclosure will be described with reference to the accompanying drawings. The term "user" used herein may refer to a person who uses an electronic device or may refer to a device (e.g., an artificial electronic device) that uses an electronic device.

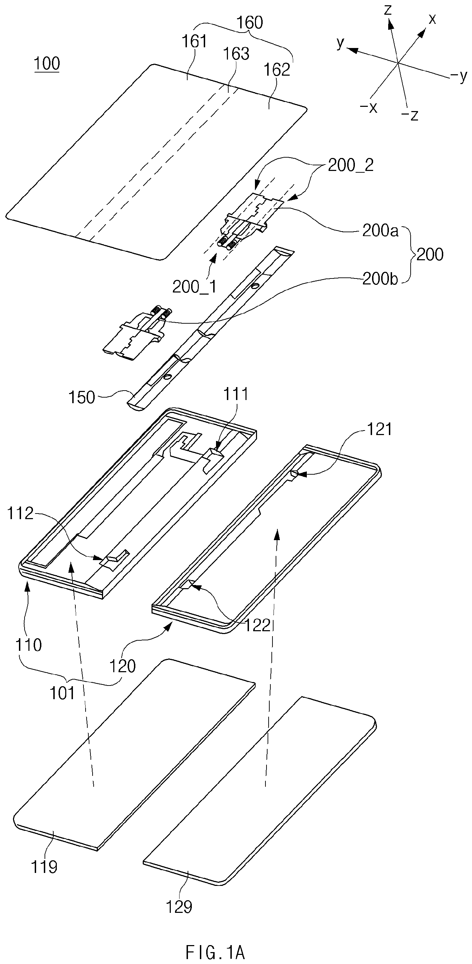

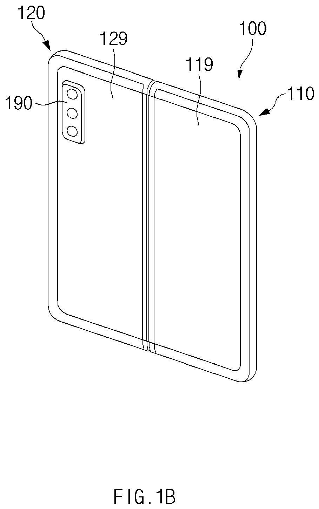

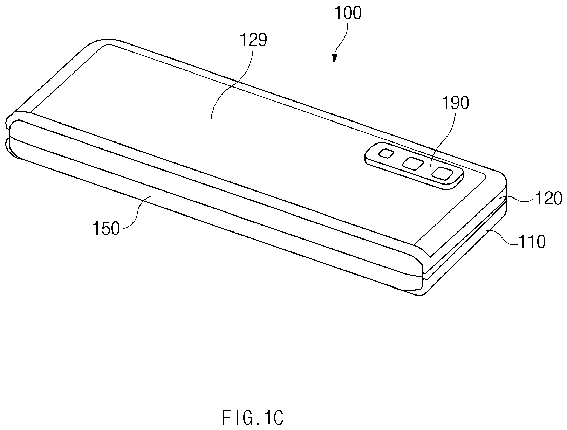

FIG. 1A is a view illustrating an exploded perspective view of an electronic device according to various embodiments. FIG. 1B is a view illustrating an example of a rear surface of the electronic device according to various embodiments. FIG. 1C is a view illustrating an example of a folded state of the electronic device according to various embodiments.

Referring to FIGS. 1A to 1C, an electronic device 100 (or a foldable electronic device, a flexible display, or a flexible & foldable electronic device) according to an embodiment, a housing 101 (e.g., a first housing 110 and a second housing 120), a hinge housing 150, a hinge structure 200 (e.g., a first hinge structure 200a and a second hinge structure 200b), and a display 160 (or a flexible display or a display module), at least a portion of which is disposed on a forward direction (e.g., the z axis direction) of the hinge structure 200. Additionally or alternatively, the electronic device 100 may further include a first cover 119 that covers at least a portion of a rear surface (e.g., a surface that faces the -z axis direction) of the first housing 110, and a second cover 129 that covers at least a portion of a rear surface (e.g., a surface that faces the -z axis direction) of the second housing 120. Furthermore, the first cover 119 may integrally form a rear surface with the first housing 110, and the second cover 129 may integrally form a rear surface with the second housing 120.

The housing 101 may be at least a pair of housings that may be rotated with respect to a specific axis. For example, the housing 101 may include the first housing 110 and the second housing 120. The first housing 110 may be disposed to be continuous to the second housing 120 (e.g., when a central portion 163 of the display 160 is spread flat or the housing 101 is in an unfolded state), or may be disposed in parallel to the second housing 120 according to a disposition form thereof. Furthermore, when the central portion 163 of the display 160 is folded, one surface of the first housing 110 may be disposed to face one surface of the second housing 120.

The first housing 110, for example, may be configured such that at least a portion thereof is formed of a metallic material or at least a portion thereof is formed of a nonmetallic material. For example, the first housing 110 may be formed of a material having a specific strength to support at least a portion of the display 160. An area (e.g., at least a portion of a first part 161 (or a first portion) of the display 160 and at least a portion of one side of the central portion 163(or a central portion)) of the display 160 may be disposed at at least a portion of the front surface of the first housing 110. Furthermore, at least a portion of the first housing 110 may be bonded to the first part 161 of the display 160. Furthermore, at least a portion of a periphery of the front surface of the first housing 110 may be bonded to a periphery of the first part 161 of the display 160. Furthermore, at least a portion of the front surface (e.g., a surface in the z axis direction) of the first housing 110 may be bonded to at least a portion of the first part 161 of the display 160. In this regard, a bonding layer may be disposed at at least a portion between the first housing 110 and the first part 161 of the display 160. At least a portion of the inside of the first housing 110 may be provided such that the interior thereof is empty or may be provided such that the interior thereof is empty after the first housing 110 is coupled to the first cover 119 so that an electronic element (e.g., an element, such as a printed circuit board, at least one processor mounted on the printed circuit board, at least one memory, or a battery) that is necessary for driving the electronic device 100 may be disposed.

According to various embodiments, peripheral ends (peripheral ends of the remaining three sites except for a periphery that faces the second housing 120 in the unfolded state of the electronic device 100) of the first housing 110 may protrude by a specific height higher than a bottom surface of a central part of the housing to surround a periphery of at least one side of the display 160. Furthermore, side walls, at least portions of which face a periphery of the display 160, may be disposed at at least a portion of the periphery end of the first housing 110. Side walls formed at at least a portion of a periphery of the first housing 110 may have specific heights at the remaining three peripheries, except for the periphery that faces the second housing 120. A peripheral portion of the first housing 110, which faces the second housing 120, may include a recessed part, at least a portion of which has a specific curvature such that at least a portion of the hinge housing 150 is disposed. For example, the first housing 110 may include, at a peripheral portion that faces the second housing 120, a first stepped portion 111 at which a portion of the first hinge structure 200a located in the hinge housing 150 is located and a second stepped portion 112 at which a portion of the second hinge structure 200b located in the hinge housing 150 is disposed.

According to various embodiments, the second housing 120, according to disposition thereof, may be disposed in parallel to the first housing 110 or may be disposed such that at least one surface thereof faces one surface (e.g., a surface on which the display 160 is disposed) of the first housing 110. For example, the second housing 120 may be formed of the same material as the first housing 110. Because the second housing 120 is disposed to be symmetrical to the first housing 110 leftwards and rightwards or upwards and downwards, at least a portion (e.g., at least a portion of a second part 162 (or a second portion) of the display 160 and at least a portion of an opposite side of the central portion 163) of the remaining area of the display 160, except for the area disposed in the first housing 110, may be disposed to be supported by a front surface of the second housing 120. Furthermore, at least a portion of the second housing 120 may be bonded to the second part 162 of the display 160. Furthermore, a periphery of the front surface of the second housing 120 may be bonded to a periphery of the second part 162 of the display 160. Furthermore, one side of a lower portion of the front surface of the second housing 120 may be bonded to one side of the second part 162 of the display 160. In this regard, a bonding layer may be disposed at at least a portion between the second housing 120 and the second part 162 of the display 160. At least a portion of the inside of the second housing 120 may be configured such that the interior thereof is empty similarly to the first housing 110 or may be configured such that the interior thereof is empty after the second housing 120 is coupled to the second cover 129 so that electronic elements that are necessary for driving the electronic device 100 may be disposed. According to various embodiments, a camera 190 may be disposed on the rear surface of the second housing 120, and in relation to the disposition of the camera 190, a hole, in which the camera 190 may be disposed, may be formed in the second cover 129.

According to various embodiments, peripheral ends (e.g., peripheral ends of the remaining three sites, except for a periphery that faces the first housing 110) of the second housing 120 may protrude by a specific height higher than a bottom surface of a central part of the second housing 120 to surround a periphery of an opposite side of the display 160. Furthermore, similarly to the side walls formed in the first housing 110, side walls, at least portions of which face the periphery of the display 160, may be disposed at at least a portion of the peripheral end of the second housing 120. Side walls formed at at least a portion of a periphery of the second housing 120 may have specific heights at the remaining three peripheries, except for the periphery that faces the first housing 110.

According to various embodiments, a portion of the second housing 120, which faces the first housing 110, may include a recessed part, at least a portion of which has a specific curvature such that the hinge housing 150 is disposed. For example, the second housing 120 may include a third stepped portion 121, at which a portion of the hinge housing 150, to which the first hinge structure 200a is mounted, is disposed at a peripheral portion that faces the first housing 110, and a fourth stepped portion 122, at which a portion of the hinge housing 150, on which the second hinge structure 200b is mounted, is disposed.

According to various embodiments, the electronic device 100 may include at least one sensor disposed on one side of an interior of the first housing 110 or the second housing 120. The sensor, for example, may include at least one of a proximity sensor, an illumination sensor, an iris sensor, an image sensor (or a camera), or a fingerprint sensor.

According to various embodiments, the hinge housing 150 may be covered by one side of the first housing 110 or the second housing 120 (e.g., an unfolded state of the housing 101) or be exposed to the outside (e.g., a folded state of the housing 101) according to the folded or unfolded state of the electronic device 100. For example, when the first housing 110 and the second housing 120 are disposed in parallel to each other, the hinge housing 150 may be covered by the first housing 110 and the second housing 120. When one surface of the first housing 110 and one surface of the second housing 120 are disposed to face each other, the hinge housing 150 may be disposed such that at least a portion thereof is exposed to the outside at peripheries (e.g., peripheries of the first housing 110 and the second housing 120, which face each other in the unfolded state) of one side of the first housing 110 and the second housing 120. A side wall may be disposed in the hinge housing 150 such that at least a portion of an interior thereof is empty and at least portions of opposite peripheries (e.g., peripheries in the x axis and -x axis directions) are closed. At least one boss coupled to the first hinge structure 200a and the second hinge structure 200b may be disposed at at least a portion of the inner surface of the hinge housing 150.

According to various embodiments, at least a portion of the display 160 may be flexible. According to an embodiment, the display 160 may include the first part 161 or the first area disposed on the first housing 110, the second part 162 or the second area disposed on the second housing 120, and the central portion 163 or a central area that are adjacent to the first housing 110 and the second housing 120 and corresponds to the location of the hinge structure 200 when the electronic device 100 is in the unfolded state. According to various embodiments, the entire display 160 may be flexible. Furthermore, at least a portion of the central portion 163 of the display 160 may be flexible. The central portion 163 of the display 160 may be disposed not to be bonded to the first housing 110 and the second housing 120. For example, the central portion 163 of the display 160 may be spaced apart from the front surface (e.g., a surface in the z axis direction) of the hinge structure 200 during the folding operation of the electronic device 100. The first part 161 of the display 160 may be bonded to at least a portion of the first housing 110, and the second part 162 of the display 160 may be bonded to at least a portion of the second housing 120. In this regard, bonding layers may be disposed in at least a partial area between the display 160 and the first housing 110 and in at least a partial area between the display 160 and the second housing 120. The display 160 may include various layers. For example, the display 160 may include an external protection layer (or a glass layer or a polymer layer) of a specific size having a specific transparency, a display panel layer disposed under the external protection layer to display a screen, and a first rear surface layer disposed under the display panel layer. The first rear surface layer may include an impact absorbing layer (or an embossing layer) and a heat dissipating layer (or a metal sheet layer). Additionally or alternatively, the first rear surface layer may further include an electromagnetic induction panel (e.g., a digitizer). According to various embodiments, the display 160 may further include a second rear surface layer disposed under the first rear surface layer. At least a portion of the second rear surface layer may include at least one metal layer (or a metal sheet) formed of a metallic material. The second rear surface layer may include a specific pattern (e.g., a lattice pattern or a slit pattern) such that at least a portion thereof may be bent. Furthermore, at least a portion of the second rear surface layer may be formed of another material (e.g., a polymer material, rubber, or a leather material) that may be bent.

According to various embodiments, at least one hinge structure 200 may be disposed with respect to the x axis direction. For example, the hinge structure 200 may include the first hinge structure 200a and the second hinge structure 200b. The hinge structure 200 may include a first part 200_1 disposed on an inside of the hinge housing 150, and a second part 200_2 disposed on the hinge housing 150 or corresponding to a peripheral structure (e.g., a structure coupled to the first housing 110 and the second housing 120) that does not overlap the hinge housing 150 with respect to the z axis. At least a portion of the first hinge structure 200a of the first part of the hinge structure 200 may be disposed on a first inner side (e.g., an area biased to the x axis direction in the hinge housing 150) of the hinge housing 150. At least a portion of the second hinge structure 200b of the first part of the hinge structure 200 may be disposed on a second inner side (e.g., an area biased to the -x axis direction in the hinge housing 150) of the hinge housing 150. At least a portion of the second part of the hinge structure 200 may be rotated in correspondence to rotation of the first housing 110 and the second housing 120. At least one of the first hinge structure 200a and the second hinge structure 200b according to an embodiment may employ a plurality of detent structures.

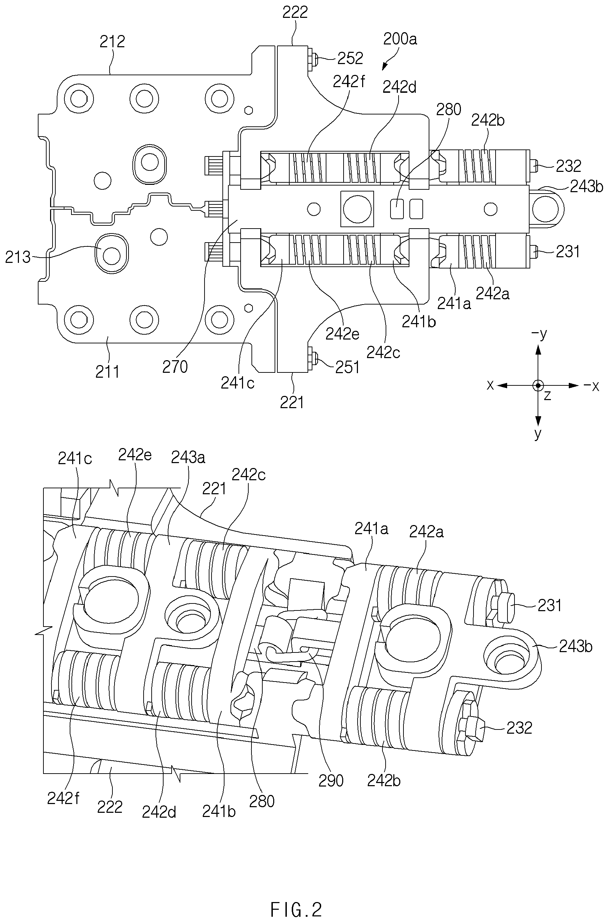

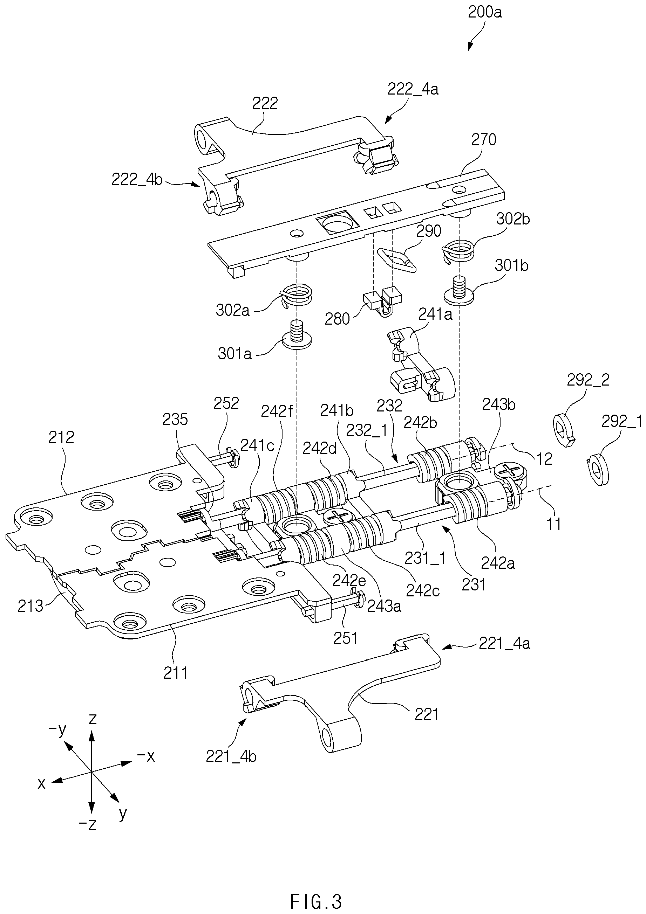

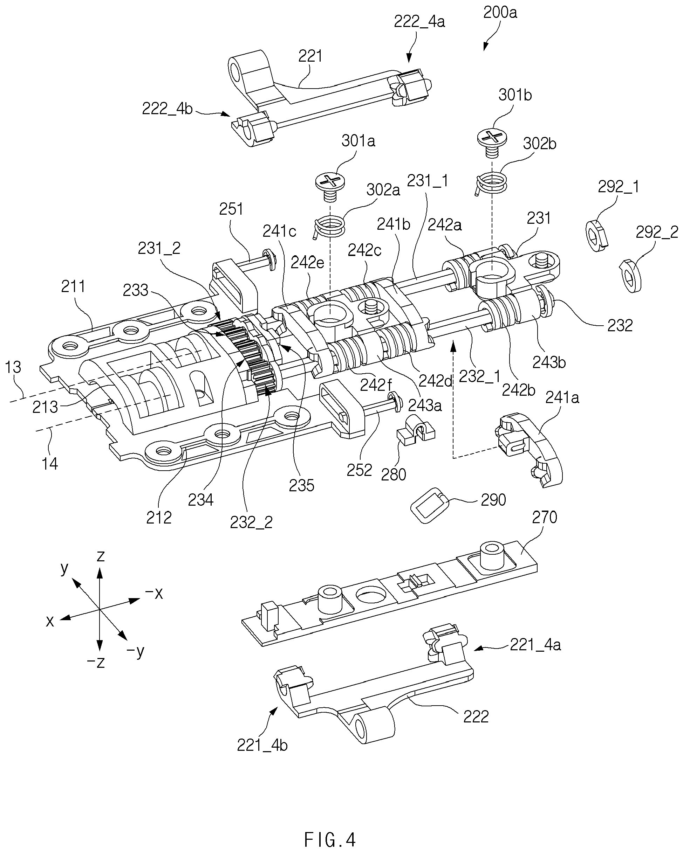

FIG. 2 is a view illustrating an example of a front surface and a rear surface of the hinge structure having a center bar according to various embodiments. FIG. 3 is a view illustrating a surface of the hinge structure in a first direction of an exploded perspective view according to various embodiments. FIG. 4 is a view illustrating a surface of the hinge structure in a second direction of an exploded perspective view according to various embodiments.

Referring to FIGS. 1 to 4, the electronic device 100 according to the present invention includes a plurality of hinge structures 200 (or hinges, hinge parts, or hinge members), and the first hinge structure 200a (or a hinge, a hinge part, or a hinge member) and the second hinge structure 200b (or a hinge, a hinge part, or a hinge member) have the same structure and form. In the following description, the first hinge structure 200a will be referenced. Although FIG. 1 suggests a structure, in which the first hinge structure 200a and the second hinge structure 200b are disposed in the hinge housing 150, the disclosure is not limited thereto, and three or more hinge structures may be mounted on the hinge housing 150.

According to the present invention, the first hinge structure 200a include rotation parts 211 and 212, a fixing bracket 213, arm parts 221 and 222 (or a first arm and a second arm, or arm portions), idle gears 233 and 234, a detent structure (e.g., a plurality of elastic bodies 242a, 242b, 242c, 242d, 242e, and 242f and cam related configurations), a center bar 270, structures (e.g., a stabilizer 290 (or a support member or a support ring) and a fixing ring 280 that couples the stabilizer 290 to the center bar 270)) that support the center bar 270.

According to the present invention, the rotation parts 211 and 212 are connected to the housings 110 and 120 that support at least a portion of the display 160 in relation to a closing or folding operation of the display 160. The rotation parts 211 and 212 may include the first rotation part 211 coupled to one side of the fixing bracket 213 and the second rotation part 212 coupled to an opposite side of the fixing bracket 213. The first rotation part 211 may be rotated (e.g., a clockwise direction or a counterclockwise direction with respect to the x axis) in a first angle range while being coupled to one side of the fixing bracket 213. The second rotation part 212 may be rotated (e.g., a counterclockwise direction or a clockwise direction with respect to the x axis) in a second angle range while being coupled to one side of the fixing bracket 213. Sizes of the first angle range and the second angle range may be the same, and directions thereof may be opposite to each other. When the electronic device 100 is in the unfolded state, a periphery of the first rotation part in the -y axis direction may be disposed to be adjacent to a periphery of the second rotation part 212 in the y axis direction. When the foldable electronic device 100 is in the folded state, an upper surface (e.g., a surface that faces the z axis direction) of the first rotation part 211 and an upper surface (e.g., a surface that faces the z axis direction) of the second rotation part 212 may be disposed to face each other. According to an embodiment, the first rotation part 211 may be rotated within a specific angle range (e.g., 0 to 100 degrees or 0 to 95 degrees) with respect to an imaginary axis that is different from a first rotary shaft 231. According to an embodiment, the second rotation part 212 may be rotated within a specific angle range (e.g., 0 to -100 degrees or 0 to -95 degrees) with respect to an imaginary axis that is different from a second rotary shaft 232. An imaginary axis related to the first rotation part 211 and an imaginary axis related to the second rotation part 212 may be located to be spaced apart from each other by a specific interval (e.g., may have a spacing distance that is larger than a distance between a center of the first rotary shaft 231 and a center of the second rotary shaft 232), may be located on the x-y axis plane, and may be located on an upper side of the center of the first rotary shaft 231 and the second rotary shaft 232 with respect to the z axis.

According to various embodiments, at least a portion of the fixing bracket 213 may be disposed in and fixed to an inner empty space of the hinge housing 150. In this regard, at least a portion of the fixing bracket 213 may have a size corresponding to the inner empty space of the hinge housing 150. Furthermore, at least a portion of the fixing bracket 213 may have a shape corresponding to the inner empty space of the hinge housing 150, for example, a semi-cylindrical shape. The fixing bracket 213 may include at least one hole, into which at least one boss formed in the hinge housing 150 may be inserted. One side of the first rotation part 211 may be disposed on one side of the fixing bracket 213 to be rotatable within a specific angle range, and one side of the second rotation part 212 may be disposed on an opposite side of the fixing bracket 213 to be rotatable within a specific angle range. One side of the first rotary shaft 231, one side of the second rotary shaft 232, and portions of the idle gears 233 and 234 may be disposed on and fixed to one side (an end in the -x axis direction) of the fixing bracket 213.

According to various embodiments, the arm parts (or the arm structures) 221 and 222 may implement detent operations while being slid on one side of the rotation parts 211 and 212 in correspondence to rotation of the rotation parts 211 and 212 of the electronic device 100, being rotated with respect to the rotary shafts (e.g., a first rotary shaft 11 and a second rotary shaft 22), and being engaged with cam members 241a, 241b, and 241c. For example, sides of the rotation parts 211 and 212 are connected to the arm parts 221 and 222 through coupling parts 251 and 252, and according to rotation of the rotation parts 211 and 212, the arm parts 221 and 222 may be slid along at least portions of sides of the rotation parts 211 and 212. The arm parts 221 and 222, for example, may include the first arm part 221 connected to the first rotation part 211 through the first coupling part 251, and the second arm part 222 connected to the second rotation part 212 through the second coupling part 252. The first arm part 221 may include a plurality of cam structures coupled to the cam members 241a, 241b, and 241c, and the second arm part 222 may include a plurality of cam structures coupled to the cam members 241a, 241b, and 241c included in a multi-detent structure 240.

According to various embodiments, the first rotary shaft 231 and the second rotary shaft 232 may provide a cam type hinge force (or a feeling of a detent). The first rotary shaft 231 and the second rotary shaft 232 may have lengths that are longer than a spacing distance between the cam structures formed in the arm parts 221 and 222. The first rotary shaft 231 and the second rotary shaft 232 may be disposed to be spaced apart from each other, and may be disposed in parallel in the x axis direction. Shaft gears 232_1 and 232_2 (or main gears) may be formed in the first rotary shaft 231 and the second rotary shaft 232, respectively, and the shaft gears 232_1 and 232_2 may be disposed to be engaged with different idle gears (e.g., the first idle gear 233 and the second idle gear 234). Accordingly, as the arm parts 221 and 222 of the hinge structure 200 shares a force generated while the first rotation part 211 and the second rotation part 212 are rotated, they may be rotated at the same or similar time points and at the same or similar angles.

According to various embodiments, one side of the first arm part 221, sides of the cam members 241a, 241b, and 241c, one side of a stopper 235, one side of a center bracket 243a, one side of a shaft bracket 243b, and a first support ring 292_1 may be inserted into the first rotary shaft 231. Additionally, a fixing member (e.g., an E ring) that may prevent separation of configurations inserted in the first rotary shaft 231 may be coupled to the end of -x axis of the first rotary shaft 231. A first shaft gear 231_2 may be formed in the first rotary shaft 231, and at least a portion of the first shaft gear 231_2 may be disposed to be engaged with the first idle gear 233. One end (e.g., an end in the x axis direction) of one side of the first rotary shaft 231 may be disposed on (or fixed to) one side surface (e.g., an end in the -x axis direction) of the fixing bracket 213.

According to various embodiments, one side of the second arm part 222, an opposite side of the stopper 235, opposite sides of the cam members 241a, 241b, and 241c, an opposite side of the center bracket 243a, an opposite side of the shaft bracket 243b, and a second support ring 292_2 may be inserted into the second rotary shaft 232. A fixing member (e.g., an E ring) that may prevent separation of configurations that are inserted into the second rotary shaft 232 similarly to the first rotary shaft 231 may be coupled to a -x axis periphery of the second rotary shaft 232. A second shaft gear 232_2 may be formed in the second rotary shaft 232, and at least a portion of the second shaft gear 232_2 may be disposed to be engaged with the second idle gear 234. One end (e.g., an end in the x axis direction) of one side of the second rotary shaft 232 may be disposed on one side surface (e.g., an end in the -x axis direction) of the fixing bracket 213.

According to various embodiments, the stopper 235 may be disposed between the gears (e.g., the shaft gears 231_2 and 232_2 and the idle gears 233 and 234) and the first arm part 221 and the second arm part 222. Recesses or holes that may fix the shaft gears 231_2 and 232_2 and the idle gears 233 and 234 may be provided on one surface of the stopper 235 in the x axis direction. One surface of the stopper 235 in the -x axis direction may include a boss coupled to one side of the first arm part 221 such that the first arm part 221 is not rotated by a specific angle or more (e.g., about 0 degrees or about 180 degrees or more with respect to the z axis), and a boss coupled to one side of the second arm part 222 such that the second arm part 222 is not rotated by a specific angle or more (e.g., about 180 degrees or about 0 degrees more with respect to the z axis). Furthermore, rings disposed in the y axis or -y axis direction may be disposed in the stopper 235, and portions of the first rotary shaft 231 and the second rotary shaft 232 may be inserted into the rings.

According to various embodiments, one side of the center bracket 243a may be inserted into the first rotary shaft 231, and an opposite side of the center bracket 243a may be inserted into the second rotary shaft 232. The center bracket 243a may be disposed between a second cam member 241b and a third cam member 241c. Furthermore, the center bracket 243a may be disposed between the third elastic body 242c and the fourth elastic body 242d, and the fifth elastic body 242e and the sixth elastic body 242f. The center bracket 243a may be fixed to the hinge housing 150 through a coupling member (e.g., a screw). The center bracket 243a may have a structure, on which the first elastic member 302a that supports the center bar 270 (or center body, or center board) and a first holding member 301a that prevents movement of the first elastic member 302a may be seated.

According to various embodiments, the shaft bracket 243b may be disposed between the support rings 292_1 and 292_2, and the first elastic body 242a and the second elastic body 242b. The shaft bracket 243b may include ring-shaped wings, into which the first rotary shaft 231 and the second rotary shaft 232 may be inserted, and may include body that supports the wings. The shaft bracket 243b may include a structure, on which a second elastic member 302b that supports the center bar 270 and a second holding member 301b, on which the second elastic member 302b is held, may be seated. The shaft bracket 243b may guide the first rotary shaft 231 and the second rotary shaft 232 such that a specific interval may be maintained therebetween while they are rotated.

According to various embodiments, the plurality of elastic bodies 242a, 242b, 242c, and 242d, for example, may include the first elastic body 242a disposed between one side of the shaft bracket 243b and the first cam member 241a, the second elastic body 242b disposed between an opposite side of the shaft bracket 243b and the first cam member 241a, the third elastic body 242c disposed between one side of the center bracket 243a and the second cam member 241b, the fourth elastic body 242d disposed between an opposite side of the center bracket 243a and the second cam member 241b, the fifth elastic body 242e disposed between the one side of the center bracket 243a and the third cam member 241c, and the sixth elastic body 242f disposed between the opposite side of the center bracket 243a and the third cam member 241c. The plurality of elastic bodies 242a, 242b, 242c, 242d, 242e, and 242f may provide elastic forces that are necessary for cam operations of the first cam member 241a, the second cam member 241b, and the third cam member 241c. According to an embodiment, to provide the same hinge force (or a feeling of a detent) during rotation of the electronic device, the first elastic body 242a and the second elastic body 242b (or the third elastic body 242c and the fourth elastic body 242d, or the fifth elastic body 242e and the sixth elastic body 242f) may have the same characteristics. For example, the plurality of elastic bodies 242a, 242b, 242c, 242d, 242e, and 242f may have spring structures that have lengths, thicknesses, and diameters that are the same or similar.

According to various embodiments, the plurality of elastic bodies 242a, 242b, 242c, 242d, 242e, and 242f may have lengths, thicknesses, or diameters that are different (e.g., the first elastic body 242a and the second elastic body 242b have a first length, a first thickness, and a first diameter that are the same or similar, and the third elastic body 242c and the fourth elastic body 242d have a second length (e.g., a second length that is different from the first length), a second thickness (e.g., a second thickness that is different from the first thickness), and a second diameter (e.g., a second diameter that is different from the first diameter)). According to various embodiments, the fifth elastic body 242e and the sixth elastic body 242f may have a third length (an x axis length), a third thickness (e.g., a thickness of a line that forms the elastic body), and a third diameter (twice of a distance from an x axis center to an outside of the elastic body) that are the same or different. The third length may be the same as or different from at least one of the first length and the second length. The third thickness may be the same as or different from at least one of the first thickness and the second thickness. The third diameter may be the same as or different from at least one of the first diameter and the second diameter.

According to various embodiments, the center bar 270 may have a bar shape, of which a length along an x axis is longer than a length along a y axis, and may be disposed between the first rotary shaft 231 and the second rotary shaft 232, and thus may be disposed to cover at least a partition space between the first rotary shaft 231 and the second rotary shaft 232. The center bar 270 may be coupled to one side of the center bracket 243a and one side of the shaft bracket 243b in the -z axis direction. The center bar 270 may be moved in the z axis or -z axis direction according to rotation of the first arm part 221 and the second arm part 222. For example, the center bar 270 may be disposed such that at least a portion thereof faces the rear surface of the display 160 in the unfolded state of the electronic device 100, and may be lowered in the -z axis direction by a specific distance to secure a distance from the display 160 such that the center bar 270 is moved in the z axis direction to support at least a portion (at least a portion of the rear surface of a folded part of the display) of rear surface of the display 160 and the display 160 is prevented from being damaged by a drop impact or an external force in the folded state of the electronic device 100. According to various embodiments, the center bar 270 may be fixed to a cam member (e.g., the first cam member 241a) while being moved in the z axis or - z axis direction by a specific distance through the stabilizer 290 or the fixing ring 280 or be fixed to the hinge housing 150 through the first cam member 241a. The above-described center bar 270 may be moved in the z axis or -z axis direction while being parallel to the x axis or y axis direction through the stabilizer 290. Accordingly, the center bar 270 may be moved upwards and downward with no collision with surrounding structures (e.g., one side of a corner of the first arm part 221 or the second arm part 222, or sides of corners of the support rings 292_1 and 292_2) in a process of folding or unfolding the electronic device 100.

The fixing ring 280 may have a U shape as a whole. The fixing ring 280 may be inserted or coupled through the holes formed on one side of the center bar 270 in the z axis. Then, one side of the stabilizer 290 may be coupled to the fixing ring 280.

The stabilizer 290 may have various shapes. For example, the stabilizer 290 may have a polygonal (e.g., quadrangular) band or a polygonal (e.g., quadrangular) ring shape as a whole. According to the present invention, the stabilizer has a band or ring shape. One side of the stabilizer 290 may be coupled to one side of the first cam member 241a, and an opposite side thereof may be coupled to one side of the fixing ring 280. The stabilizer 290 may include a gap 290a formed by breaking one side of the band shape for coupling to one side of the fixing ring 280 or the first cam member 241a. According to various embodiments, the gap 290a may be removed by using a specific scheme (e.g., a 3D printer scheme). The stabilizer 290 may restrain movement of the center bar 270 while the center bar 270 is moved in the z axis or -z axis direction, and may guide the center bar 270 such that the center bar 270 is moved in a specific range. For example, while the center bar 270 is raised in the z axis direction, an inclination of the stabilizer 290 may be changed (e.g., an inclination from the x-y plane increases) as the center bar 270 and the fixing ring 280 is moved in the z axis while an angle from the x-y plane becomes larger. While the center bar 270 is lowered in the -z axis direction, an inclination of the stabilizer 290 may be changed (e.g., the inclination from the x-y plane decreases) as the center bar 270 and the fixing ring 280 is moved in the -z axis while the angle from the x-y plane becomes smaller.

Additionally, a fixing member (e.g., an E ring) may be disposed at ends of the coupling parts 251 and 252 and ends of the first rotary shaft 231 and the second rotary shaft 232 to prevent separation of related configurations (e.g., the coupling parts 251 and 252, the arm parts 221 and 222, the rotation parts 211 and 212, or the support rings 292_1 and 292_2 and the rotary shafts 231 and 232).

As described above, the hinge structures 200a and 200b according to the present invention stably fix and support the center bar 270 by using the fixing ring 280 and the stabilizer 290, in a structure of the center bar 270 that is coupled to the hinge housing 150 and the housings 110 and 120 to support at least a portion of the display 160 positioned on an upper side, to prevent leftward and rightward inclinations even when the center bar 270 is moved upwards and downwards.

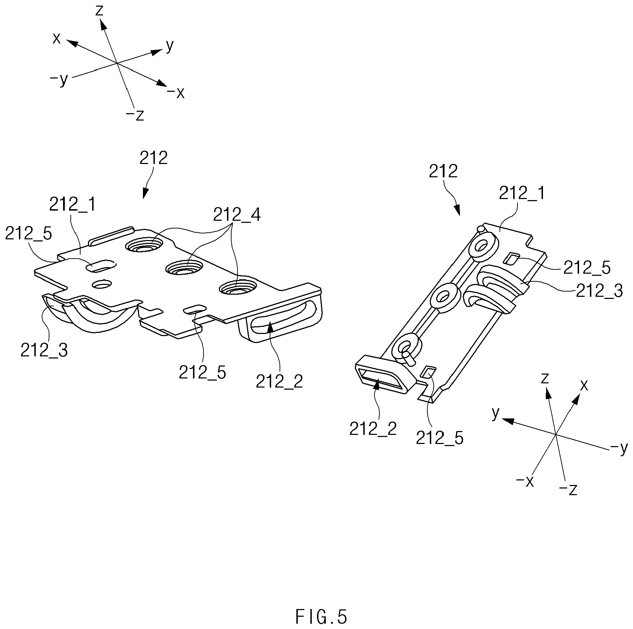

FIG. 5 is a view illustrating an example of the rotation part according to an embodiment. Prior to a description, the rotation part illustrated in FIG. 5 exemplifies the second rotation part described above in FIGS. 3 and 4. At least a portion of the second rotation part 212 may have a structure that is symmetrical to the first rotation part 211 leftwards and rightwards with respect to the center lines of the first rotary shaft 231 and the second rotary shaft 232. The second rotation part 212 may have a shape and a material that are the same as those of the first rotation part 211. Although a location of a configuration, for example, a rail of the second rotation part 212 may be different from a location of a rail of the first rotation part 211, overall shapes thereof may be similar. In the following description, the second rotation part 212 will be described as a representative example of the structure of the rotation part of the electronic device.

Referring to FIG. 5, the second rotation part 212 may include a bracket body 212_1, a slide hole 212_2 formed at an end (e.g., an end in the -x axis direction) on one side of the bracket body 212_1, a rail 212_3 formed at an end (e.g., an end in the -y axis direction) on an opposite side of the bracket body 212_1, and a housing coupling hole 212_4 used for coupling to the second housing 120 (e.g., the second housing 120 of FIG. 1). The first rotation part 211 described above in FIG. 3 or FIG. 4, similarly to the second rotation part 212, may include a bracket body, a slide hole, a rail, and a housing coupling hole. A location of the rail of the first rotation part 211 may be different from a location of the rail of the second rotation part 212.

According to various embodiments, an x axis length of the bracket body 212 _1 may be larger than a y axis length thereof, at least a portion of a surface thereof, which faces the z axis may be flat, and at least a portion of a surface thereof, which faces the -z axis also may be flat. With reference to the illustrated drawings, the slide hole 212_2 may be formed at a right end (e.g., an end in the -x axis direction) of the bracket body 212_1 to face a downward direction (e.g., -z axis direction). The rail 212_3 may be disposed at an end (e.g., an end in the -y axis direction) of one side of the bracket body 212_1 to face a lower surface (e.g., a surface in the -z axis direction). At least one housing coupling hole 212_4 used for coupling to the second housing 120 may be disposed in the bracket body 212_1. In the illustrated drawings, a form, in which three housing coupling holes 212_4 are disposed, is illustrated, the disclosure is not limited thereto. For example, two or more housing coupling holes 212_4 may be formed, and the two or more housing coupling holes 212_4 may be disposed to be spaced apart from the bracket body 212_1. According to various embodiments, at least one bracket coupling hole 212_5 may be disposed in the bracket body 212_1. The bracket coupling hole 212_5 may be coupled to a coupling boss formed in the fixing bracket 213 when the electronic device 100 is in the unfolded state, and may be separated from the coupling boss of the fixing bracket 213 when the electronic device 100 is in the folded state. The number of bracket coupling holes 212_5 may correspond to the number of coupling bosses of the fixing bracket 213.

According to various embodiments, the slide hole 212_2 may be disposed at an opposite end (e.g., an end in the -x axis direction) of the bracket body 212_1, and may be disposed at a lower portion of the bracket body 212_1. A length of the slide hole 212_2 in the first direction (e.g., the y axis direction) may be longer than a length thereof in a third direction (e.g., the x axis direction). Accordingly, the second coupling part 252 inserted into the slide hole 212_2 may be slid in any one of the first direction (e.g., the y axis direction) and the second direction (e.g., the -y axis direction) in the slide hole 212_2. The slide hole 212_2 may be disposed to face a surface (e.g., a surface disposed in the -x axis direction) in a fourth direction of the second arm part 222. At least a partial area of the slide hole 212_2 may be aligned with a hole formed on one side of the second arm part 222. Accordingly, at least a portion of the second coupling part 252 may be disposed in the slide hole 212_2 and a hole of the arm part 222.

According to various embodiments, the rail 212_3 may be disposed at an end (e.g., an end in the -y axis direction) of the bracket body 212_1 in the second direction, and may be disposed at a lower portion of the bracket body 212_1. The rail 212_3 may have an arc shape of a specific angle. The rail 212_3 may be inserted into a rail grove (or a rail type hole) disposed in the fixing bracket 213, and may be rotated along the rail groove in a specific rotation range. According to an embodiment, the rotation range of the rail 212_3 may be included within an angle of an arc that forms the shape of the rail 212_3. For example, the rotation range of the rail 212_3 may be at least a partial range (e.g., a range of 0 degrees to 95 degrees) in -10 degrees to 100 degrees. The rail 212_3 may be rotated between the -z axis and the z axis with respect to a fourth axis 14 formed by the rail groove of the fixing bracket 213.

The housing coupling hole 212_4 may be formed on one side (e.g., a periphery of one side that faces the y axis direction) of the bracket body 212_1, and may be formed to pass through a surface (e.g., a surface in the y axis direction) in the first direction and a surface (e.g., a surface in the -y axis direction) in the second direction. Although it is exemplified in the illustrated drawings that three housing coupling holes 212_4 are formed in the bracket body 212_1, the disclosure is not limited to the number.

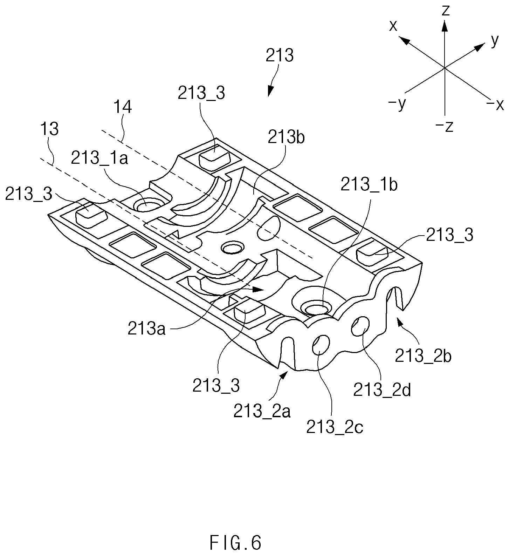

FIG. 6 is a view illustrating an example of a fixing bracket according to an embodiment.

Referring to FIGS. 3 to 6, at least a portion of a shape of a lower surface (e.g., a surface in the -z axis direction) of the fixing bracket 213 may include a curved surface. For example, a lower surface of the fixing bracket 213 may be formed to correspond to an inner shape of the hinge housing (e.g., the hinge housing 150 of FIG. 1). At least a portion of the upper surface (e.g., a surface in the z axis direction) of the fixing bracket 213 may have a flat shape, and rail grooves (or the rail grooves) 213a and 213b may be formed such that the rotary brackets (e.g., the rotary brackets 211 and 212 of FIG. 1) are coupled thereto.

According to an embodiment, the fixing bracket 213 may include the first rail groove 213a, of which at least a portion of a z axis cross-section (e.g., a cross-section taken from the z axis direction to the -z axis direction) has an arc shape, and into which the rail of the first rotation part 211 is inserted from the first direction (e.g., the y axis direction) to the second direction (the -y axis direction). According to an embodiment, the fixing bracket 213 may include the second rail groove 213b, of which at least a portion of a z axis cross-section (e.g., a cross-section taken from the z axis direction to the -z axis direction) has an arc shape, and into which the rail 212_3 of the second rotation part 212 is inserted from the second direction (e.g., the -y axis direction) to the first direction (the y axis direction). The first rail groove 213a may be disposed to be biased to the -y axis direction as compared with the second rail groove 213b, and the second rail groove 213b may be disposed to be biased to the y axis direction as compared with the first rail groove 213a. The first rail groove 213a may be rotated with respect to a third axis 13, and the second rail groove 213b may be rotated with respect to the fourth axis 14.

The third axis 13 and the fourth axis 14 may be formed on an upper side of an upper surface (e.g., a surface in the z axis direction) of the fixing bracket 213, and the third axis 13 and the fourth axis 14 may be formed to be spaced apart from each other by the first rail groove 213a disposed to be biased in the -y axis direction and the second rail groove 213b disposed to be biased in the y axis direction. According to an embodiment, the fixing bracket 213 may include a first recess 213_2a formed at a side thereof disposed in the -x axis direction and in which one end of the first rotary shaft 231 is disposed, and a second recess 213_2b, in which one end of the second rotary shaft 232 is disposed. According to various embodiments, the fixing bracket 213 may include a third recess 213_2c formed at a side thereof in the -x axis direction and in which the first idle gear 233 is held, and a fourth recess 213_2d, in which the second idle gear 234 is held. The third recess 213_2c and the fourth recess 213_2c may be disposed between the first recess 213_2a and the second recess 213_2b.

According to various embodiments, the fixing bracket 213 may include a first fixing hole 213_1a and a second fixing hole 213_1b that are used to fix the fixing bracket 213 to the hinge housing 150. In the electronic device 100, the fixing bracket 213 may be fixed to the hinge housing 150 by using a coupling member (e.g., a coupling member such as a screw). According to an embodiment, the first fixing hole 213_1a and the second fixing hole 213_1b may be disposed to be symmetrical to each other in a diagonal direction from the upper surface (e.g., a surface in the z axis direction) of the fixing bracket 213 to fix the fixing bracket 213 to the hinge housing 150 more firmly and stably.

According to various embodiments, the fixing bracket 213 may include at least one bracket boss 213_3 inserted into a bracket coupling hole (e.g., bracket coupling hole corresponding to the bracket coupling hole 212_5 of the second rotation part 212) formed in the first rotation part 211. Additionally, the bracket coupling hole 212_5 also may be formed in the second rotation part 212 in the same way as the first rotation part 211, and the fixing bracket 213 may include bracket bosses having the same shape at locations that are symmetrical to the bracket boss 213_3 inserted into the bracket coupling hole of the first rotation part 211 with respect to the -x axis. According to an embodiment, a plurality of bracket bosses 213_3 may be disposed on a surface of the fixing bracket 213 in the z axis direction. For example, the plurality of bracket bosses 213_3 may be disposed at corners of a surface of the fixing bracket 213 in the z axis direction.

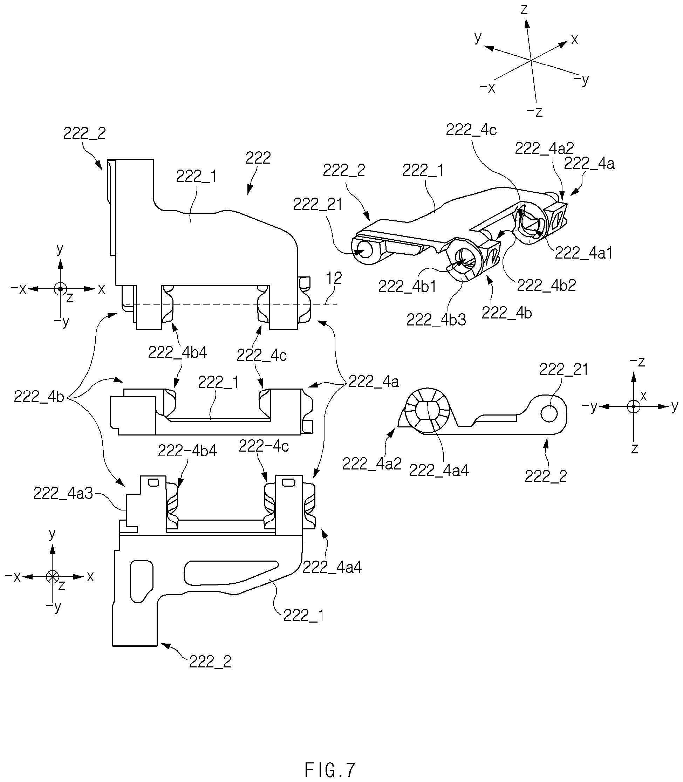

FIG. 7 is a view illustrating an example of the arm part according to an embodiment. Prior to a description, the arm part illustrated in FIG. 7 is a view illustrating a second arm part with reference to FIG. 3. The second arm part 222 may have a shape (e.g., a shape that is symmetrical with respect to the x axis) that is similar to that of the first arm part 221, and may have a size and a material that are the same as those of the first arm part 221. In the following description, among the first arm part and the second arm part of FIG. 3, the second arm part will be referenced. According to various embodiments, disposition angles of a first coupling hole 222_4a1 of the first arm part 221 and a second coupling hole 222_4b1 of the second arm part 222 may be different.

Referring to FIGS. 3 and 7, the second arm part 222 may be coupled to the second rotation part 212 through the second coupling part (e.g., the second coupling part 252 of FIG. 3), and may be rotated in conjunction with the second rotation part 212 during a hinge operation. According to an embodiment, the second arm part 222 may include a basic body 222_1, a connector 222_2, a third cam structure 222_4a, and a fourth cam structure 222_4b. Similarly, the second arm part 221 may include a basic body corresponding to the basic body 222_1, a connector corresponding to the connector 222_2, a fifth cam structure corresponding to the third cam structure 222_4a, and a sixth cam structure corresponding to the fourth cam structure 222_4b.

According to various embodiments, at least a portion of an upper surface (e.g., a surface disposed in the z axis direction) of the basic body 222_1 may be formed flat. The connector 222_2 may be disposed at at least a portion of a lower surface (e.g., a surface in the -z axis direction) of an upper periphery (e.g., an end in the y axis direction) of the basic body 222_1. The connector 222_2 may be a ring shape or a pipe shape having a specific thickness. For example, the connector 222 2 may include a hole 222_21 that is opened in the third direction (e.g., the x axis direction) (or the -x axis direction). At least a portion of the second coupling part 252 may be disposed in the hole 222_21 of the connector 222_2. In this regard, a size of the hole 222_21 of the connector 222_2 may have a size that is similar to a diameter of the second coupling part 252. The third cam structure 222_4a and the fourth cam structure 222_4b may be disposed on a lower surface (e.g., a surface in the -z axis direction) of a periphery (e.g., an end in the -y axis direction) on a lower side of the basic body 222_1. The third cam structure 222_4a and the fourth cam structure 222_4b may be disposed at a periphery of the basic body 222_1 in the -y axis direction, and the connector 222 2 may be disposed at a periphery of the basic body 222_1 in the y axis direction.

According to various embodiments, the third cam structure 222_4a may include the first coupling hole 222_4a1 that faces the -x axis direction from the x axis, a first holding part 222_4a2 that supports the center bar 270, a first cam boss 222_4a4 for a cam operation, and a second cam boss 222_4c disposed in the -y axis direction to perform a cam operation.

According to various embodiments, at least a portion of the second rotary shaft 232 may be inserted into the first coupling hole 222_4a1. The first coupling hole 222_4a1 may have a shape that is the same as or similar to a cross-section (e.g., a cross-section taken from the z axis direction to the -z axis direction) of one side of the second rotary shaft 232. For example, at least a partial cross-section (e.g., a cross-section of the first coupling hole 222_4a1 when the third cam structure 222_4a is taken from the z axis direction to the -z axis direction) of at least a portion of the first coupling hole 222_4a1. The first coupling hole 222_4a1 may be disposed on the same axis (e.g., a second axis 12) as the second coupling hole 222_4b1 of the fourth cam structure 222_4b.

According to various embodiments, the first holding part 222_4a2 may protrude from one side of a peripheral portion that forms the first coupling hole 222_4a1 in the -y axis direction by a specific length. At least a portion of a z axis cross-section of the first holding part 222_4a2 may have a triangular shape. According to various embodiments, a size of the z axis cross-section of the first holding part 222_4a2 may gradually decrease as it goes from the y axis to the - y axis. An upper surface (e.g., a surface that faces the z axis direction) of the first holding part 222_4a2 may be lower than an upper surface (e.g., a surface that faces the z axis direction) of the basic body 222_1 with respect to the z axis. According to an embodiment, the first holding part 222_4a2 may protrude from a side (e.g., one point in the -y axis direction) of a peripheral portion of the first coupling hole 222_4a1 in the -y axis direction while being located between an upper side (e.g., one point in the z axis direction) and a lower side (e.g., one point in the -z axis direction) of the peripheral portion that forms the first coupling hole 222_4a1. The first holding part 222_4a2 may be integrally formed with the peripheral portion that forms the first coupling hole 222_4a1. In this regard, the first holding part 222_4a2 may be formed of the same material as that of the peripheral portion of the first coupling hole 222_4a1 or the basic body 222_1.

According to various embodiments, the first cam boss 222_4a4 may protrude from a side surface of the peripheral portion of the first coupling hole 222_4a1, which face the -x axis direction, in the -x axis direction by a specific height, and protrusion heights thereof may be different according to locations. For example, a z axis cross-section (e.g., a cross-section from the z axis direction to the -z axis direction) of the first cam boss 222_4a4 may be circular, or at least a portion thereof includes a line and a remaining portion thereof may include a curve (at least a portion thereof may include a D-cut shape). The first cam boss 222_4a4 may have a convexo-concave shape in the -x axis direction. At least a portion of the first cam boss 222_4a4 having the convexo-concave shape in the -x axis direction may include a curve section. Heights of mountains of the convexo-concave shape are the same in the -x axis direction, and depths of valleys of the convexo-concave shape may be the same in the x axis direction. Central portions of the mountains and the valleys of the convexo-concave shape may include flat areas of a specific length. The second cam boss 222_4c may have a shape that is the same as or similar to that of the first cam boss 222_4a4. The second cam boss 222_4c may be disposed in a direction that is opposite to a direction, in which the first cam boss 222_4a4 is formed, for example, in the x axis direction.

According to various embodiments, a fourth cam structure 222_4b may include the second coupling hole 222_4b1 of a uniform diameter that faces the -x axis direction from the x axis, a second holding part 222_4b2 that supports the center bar 270, a boss 222_4b3, at least a portion of which is engaged with a stopper 236, and a third cam boss 222_4b4 for a cam operation. The fourth cam structure 222_4b may be disposed to be spaced apart from the third cam structure 222_4a by a specific interval while being disposed on one side of the basic body 222_1. A spacing distance between the third cam structure 222_4a and the fourth cam structure 222_4b may be changed according to a size or a shape of at least one of the elastic bodies disposed between the third cam structure 222_4a and the fourth cam structure 222_4b, the cam member, and the center bracket 243a.

According to various embodiments, at least a portion of the second rotary shaft 232 may be inserted into the second coupling hole 222_4b1. The second coupling hole 222_4b1 may have a shape that is the same as or similar to a cross-section (e.g., a cross-section taken from the z axis direction to the -z axis direction) of one side of the second rotary shaft 232. A cross-section (e.g., a cross-section taken from the z axis direction to the -z axis direction) of at least a portion of the second coupling hole 222_4b1 may have the same shape as that of the first coupling hole 222_4a1. The second coupling hole 222_4b 1 may be disposed on the same axis (e.g., the second axis 12) as the first coupling hole 222_4a1 of the fourth cam structure 222_4b.

According to various embodiments, the second holding part 222_4b2 may have a shape that is the same as or similar to that of the first holding part 222_4a2. For example, the second holding part 222_4b2 may be formed between an upper side (e.g., one point in the z axis direction) and a lower side (e.g., one point in the -z axis direction) of the peripheral portion of the second coupling hole 222_4b1, and may protrude in the -y axis direction. According to an embodiment, similarly to the first holding part 222_4a2, the second holding part 222_4b2 may have a shape, of which a width of the protrusion gradually decreases as it goes from the z axis direction to the -z axis direction.

According to various embodiments, the boss 222_4b3 may protrude in the -x axis direction by a specific length while having a specific thickness, on a surface of the peripheral portion of the second coupling hole 222_4b1, which faces the -x axis direction. According to an embodiment, the protrusion height of the boss 222_4b3 may correspond to a shape of one side of the stopper 236. A thickness of the boss 222_4b3 may be the same as a width of the peripheral portion of the second coupling hole 222_4b1, and may have an area that is smaller than the entire area of the peripheral portion. The boss 222_4b3 may define a limit angle, by which the second arm part 222 is rotated in a specific angle range (e.g., 0 degrees to 100 degrees or 0 degrees to -100 degrees).

According to various embodiments, the third cam boss 222_4b4 may have a shape that is the same as or similar to that of the first cam boss 222_4a4. According to various embodiments, the third cam boss 222_4b4 may include a convexo-concave shape that protrudes in the x axis direction, on a surface of the peripheral portion of the second coupling hole 222_4b1, which faces the x axis direction. The third cam boss 222_4b4 may include at least one mountain and at least one valley. A central portion of the mountain or the valley of the third cam boss 222_4b4 may be flat. A size (e.g., a size of the flat area) of a specific area of the central portion of the mountain or the valley of the third cam boss 222_4b4 may be the same as a size of a specific area of the central portion of the mountain or the valley of the first cam boss 222_4a4. According to various embodiments, a size (e.g., a size of the flat area) of a specific area of the central portion of the mountain or the valley of the third cam boss 222_4b4 may be different from as a size of a specific area of the central portion of the mountain or the valley of the first cam boss 222_4a4 such that a hinge force (or a feeling of a detent) may be provided more smoothly.

According to various embodiments, the number and directions of the bosses (or convex-concave shape or the mountains and the valleys) of the third cam structure 222_4a and the fourth cam structure 222_4b may be added or eliminated. For example, according to various embodiments, the second cam boss 222_4c of the third cam structure 222_4a may be removed. Furthermore, a plurality of bosses also may be disposed in the fourth cam structure 222_4b in different directions (e.g., the x axis direction and the -x axis direction). Directions of the fixed cams also are disposed such that the fixed cams are engaged with the cam structures 222_4a and 222_4b according to disposition directions of the bosses of the cam structures 222_4a and 222_4b.

According to various embodiments, the second arm part 222 of the above-described structure may be rotated with respect to the second rotary shaft 232. In a state, in which one side of the first cam member 241a is engaged with the third cam structure 222_4a and one side of the second cam member 241b is engaged with the fourth cam structure 222_4b, the second elastic body 242b may provide an elastic force to the one side of the first cam member 241a and the third cam structure 222_4a, and the fourth elastic body 242d may provide an elastic force to the one side of the second cam member 241b and the fourth cam structure 222_4b. According to an embodiment, the third cam structure 222_4a and the fourth cam structure 222_4b may perform cam operations at the same time or in multiply stages. According to an embodiment, the electronic device 100 may divide the cam structure for cam operations to the third cam structure 222_4a and the fourth cam structure 222_4b, and thus may provide a high elastic force without increasing the thickness of the electronic device 100 because the sizes of the elastic bodies (e.g., the diameters of the elastic bodies) or the thicknesses of the elastic bodies (e.g., the widths of lines that form the elastic bodies) are not increased. Furthermore, because the electronic device 100 may provide a robust and improved hinge force (or feeling of a detent or pressure) through the high elastic forces, the folded or unfolded state of the electronic device 100 may be stably provided even when a tensile force, a strength, or a repulsive force (e.g., an increased thickness) of the display is increased. The electronic device 100 may provide various holding angles more stably by using the arm part including the plurality of cam structures.

Meanwhile, the second arm part 222 including the third cam structure 222_4a and the fourth cam structure 222_4b, which have been described above, may have configurations and shapes that are the same as or similar to those of the first arm part 221 including a first cam structure 221_4a and a second cam structure 221_4b, with respect to a first axis 11 or the second axis 12.

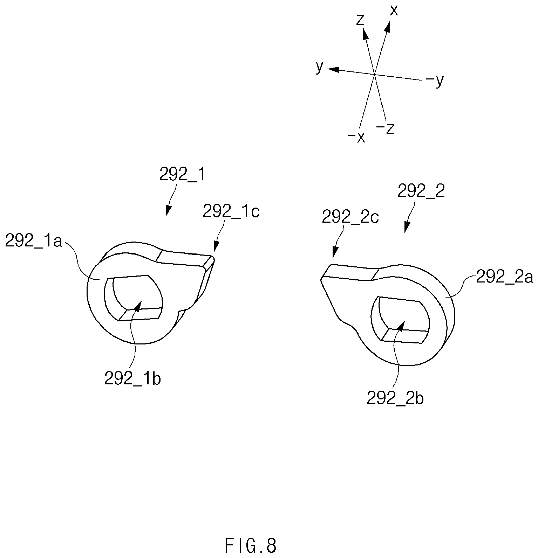

FIG. 8 is a view illustrating an example of the support rings according to various embodiments.

Referring to FIGS. 3 to 8, the support rings 292_1 and 292_2 according to an embodiment may include the first support ring 292_1 coupled to the first rotary shaft 231 and the second support ring 292 2 coupled to the second rotary shaft 232.

According to various embodiments, the first support ring 292_1 may include a first ring hole 292_1b, into which the first rotary shaft 231 is inserted, and a first ring body 292_1a that defines the first ring hole 292_1b. The first ring hole 292_1b may be disposed in a center part of the first ring body 292_1a, and the first ring body 292_1a may have a ring shape as a whole. The first ring body 292_1a may include a first support boss 292_1c that provides from one side of an outer peripheral surface thereof in the -y axis direction. The first support boss 292_1c may have a shape (e.g., a triangular shape), a width of which decreases as it becomes farther away from the first ring body 292_1a. At least a portion of an upper surface (a surface that faces the z axis) of the first support boss 292_1c may be formed to be flat, and at least a portion of a lower cross-section (e.g., a cross-section taken along from the z axis to the direction of the -z axis) may include a curve. The first support boss 292_1c may support one side of the center bar 270 while the first arm part 221 and the second arm part 222 are disposed on the y axis to be parallel to each other. The first ring hole 292_1b may have a cross-section that is the same as or similar to a z axis cross-section (e.g., a cross-section taken from the -z axis direction to the z axis direction) of the first rotary shaft 231. For example, a z axis cross-section (a cross-section taken along from the z axis to the direction of the -z axis) of at least a portion of the first ring hole 292_1b may include a linear section, and the remaining sections may include a circular section. Alternatively, the first ring hole 292_1b may have a shape, in which linear sections and circular sections are alternately disposed in the z axis cross-section (e.g., a cross-section taken along from the z axis to the direction of the -z axis). Accordingly, when the first rotary shaft 231 is rotated in one direction, the first support ring 292_1 may be rotated in the same direction as that of the first rotary shaft 231.

According to various embodiments, the second support ring 292_2 may include a second ring hole 292_2b, into which the second rotary shaft 232 is inserted, and a second ring body 292_2a that defines the second ring hole 292_2b. A second support boss 292_2c may be disposed on one side of the second ring body 292_2a. The second ring hole 292_2b may have a shape that is the same as or similar to that of the first ring hole 292_1b. Alternatively, the second ring hole 292_2b may have a shape that is the same as or similar to a z axis cross-section (e.g., a cross-section taken from the -z axis direction to the z axis direction) of the second rotary shaft 232. The second ring body 292_2a may a shape that is the same or similar to those of the first ring body 292_1a. The second support boss 292_2c may be disposed to protrude from one side of the second ring body 292_2a in the y axis direction. The second support boss 292_2c may have a shape (e.g., a triangular shape), of which a size of at least a portion of a cross-section (e.g., a cross-section taken along from the z axis to the direction of the -z axis) gradually decreases similarly to the first support boss 292_1c. In a state, in which the first arm part 221 and the second arm part 222 are parallel to each other in the y axis (e.g., the display of the electronic device is in an unfolded state), an apex of the second support boss 292_2c may face an apex of the first support boss 292_1c. Accordingly, when the electronic device is in the unfolded state, the second support boss 292_2c may support one side of the center bar 270 similarly to the first support boss 292_1c.

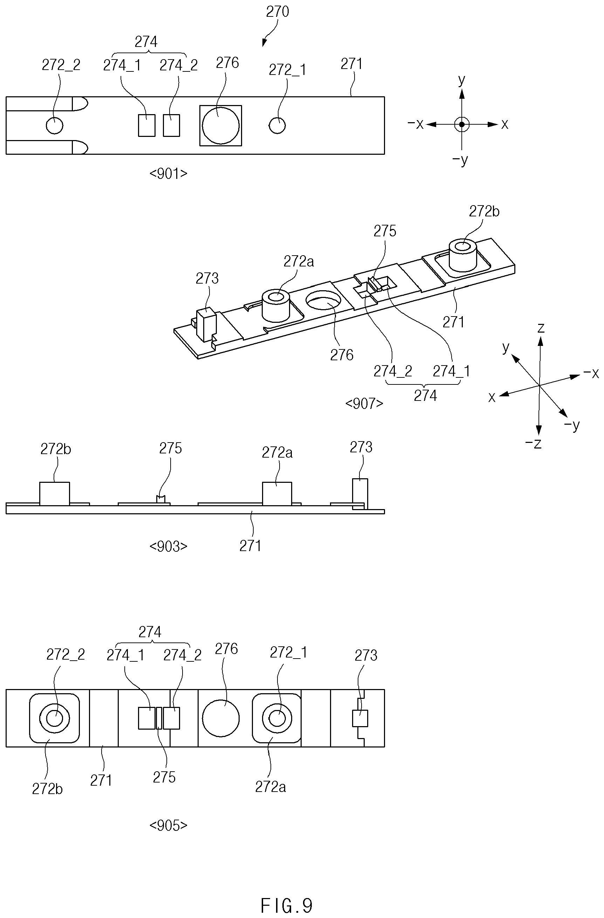

FIG. 9 is a view illustrating an example of the center bar according to various embodiments.

Referring to FIGS. 3 to 9, the center bar 270 according to an embodiment may include a center body 271, a first center boss 272a formed in a direction (e.g., -z axis direction) of a lower surface of the center body 271, a second center boss 272b, a third center boss 273, a ring connector 274, and an opening 276.

At least a portion of an upper surface of the center body 271 in a direction (e.g., the z axis direction) that faces the display 160 may be formed to be flat. The center body 271 may have a panel shape, of which a length in an x axis direction is larger than a length in a y axis direction and of which a thickness in the z axis is smaller than a width in a y axis direction. According to an embodiment, a size of the center body 271 may correspond to an interval between the first rotary shaft 231 and the second rotary shaft 232. The first center boss 272a, the second center boss 272b, and the third center boss 273 may be disposed in the -z axis direction of the center body 271, and at least one opening that passes through a z axis and -z axis directions of the center body 271. The center body 271 may be formed of a metallic material, but may be formed of various nonmetallic materials that may support the display 160 while having a specific strength.

The first center boss 272a may include a cylindrical boss that protrudes from one side of the center body 271 in the -z axis direction by a specific height. A central portion of the first center boss 272a may have a first center hole 272_1 that passes from the -z axis to the direction of the z axis. According to an embodiment, a height of the first center boss 272a may be smaller than a depth of the hole of the center bracket 243a. The first center boss 272a, for example, may be disposed between the second center boss 272b and the third center boss 273. Alternatively, the first center boss 272a may be disposed between the third center boss 273 and the opening 276. The first elastic member 302a that supports the center bar 270 based on an elastic force may be coupled to the first center boss 272a. The first center hole 272_1 may be omitted. At least a portion of an inside of the first center boss 272a may include an empty space, and at least a portion of the first holding member 301a may be inserted into the first center boss 272a.

The second center boss 272b may include a cylindrical boss that protrudes from one side of the center body 271 in the -z axis direction by a specific height, similarly to the first center boss 272a. The second center boss 272b may have a second center hole 272_2 that passes through a central portion thereof from the -z axis to the direction of the z axis, like the first center boss 272a. According to an embodiment, a height of the second center boss 272b may have a height that is the same as that of the first center boss 272a. Alternatively, the second center boss 272b may be shorter than a depth of the hole of the inserted center bracket 243a. The second elastic member 302b that supports the center bar 270 based on an elastic force may be coupled to the second center boss 272b. The second center boss 272b, for example, may be disposed at a periphery of the center body 271 in the -x axis direction. The second center hole 272_2 may be omitted. At least a portion of an inside of the second center boss 272b may include an empty space like the first center boss 272a, and at least a portion of the second holding member 301b may be inserted into the second center boss 272b.

The third center boss 273 may be disposed at a periphery of the center body 271 in the x axis direction. The third center boss 273 may have a height that is similar to or the same as that of the first center boss 272a or the second center boss 272b. The third center boss 273 may be disposed between the stopper 235 and the third cam member 241c when the center bar 270 is positioned between the first rotary shaft 231 and the second rotary shaft 232 to prevent movement of the center bar 270 in the x axis direction when the center bar 270 is moved in the z axis direction and to guide the center body 271 such that the center body 271 is stably moved in the z axis direction.

The ring connector 274 may include a first ring connecting hole 274_1, a second ring connecting hole 274_2, and a fixing boss 275 that supports the fixing ring 280 such that the fixing ring 280 is inserted and fixed. The first ring connecting hole 274_1 and the second ring connecting hole 274_2 may be disposed to be spaced apart from each other by a specific interval, and may be formed to pass through the z axis and the -z axis of the center body 271. An interval between the first ring connecting hole 274_1 and the second ring connecting hole 274_2 may be changed according to a form of the fixing ring 280. A portion of a first leg 281 of the fixing ring 280 may be inserted into the first ring connecting hole 274_1, and a portion of a second leg 282 of the fixing ring 280 may be inserted into the second ring connecting hole 274_2. Even when the fixing ring 280 is coupled to the ring connector 274, an upper surface of the ring connector 274, to which the fixing ring 280 is coupled, may have the same height as that of a periphery thereof. In this regard, the first ring connecting hole 274_1 and the second ring connecting hole 274_2 may include steps, on which portions of the first leg 281 and the second leg 282 of the fixing ring 280 may be seated. The fixing boss 275 may protrude from a surface of the center body 271 in the -z axis direction by a specific height in the -z axis direction. An end of the fixing boss 275 in the -z axis direction may have a shape that is concave in the z axis direction in relation to support of the fixing ring 280. Through this, the fixing boss 275 may support the fixing ring 280 more firmly.

The opening 276 may be disposed to pass through the upper and lower sides of the center body 271 in the z axis and the -z axis. A reference cross-section of the opening 276 on the x-y plane, for example, may be circular. The opening 276 may be used to insert a coupling member (e.g., a screw) used to fix the center bracket 243a to the hinge housing 150. Accordingly, while the center bar 270 is coupled to the stabilizer 290 and the fixing ring 280, at least a portion of the coupling member that couples the center bracket 243a to the hinge housing 150 may be exposed in the z axis direction through the opening 276.

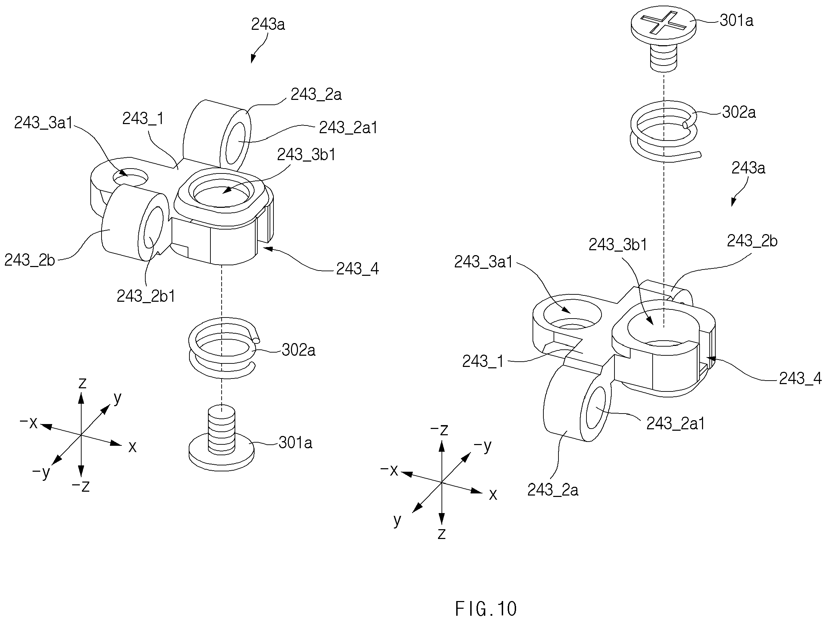

FIG. 10 is a view illustrating an example of the center bracket according to various embodiments.

Referring to FIGS. 3 and 10, the center bracket 243a according to an embodiment may involve in the z axis movement of the center bar 270 (e.g., guide the movement range of the center bar 270) while supporting the center bar 270. The center bracket 243a may include a center body 243_1, a first center wing part 243a1 and a second center wing part 243a2, a center coupling hole 243 _3al, and a holding hole 243_3b1.

According to various embodiments, the center body 243_1 may include a configuration that extends in the x axis or -x axis direction and the y axis or - y axis direction, and may have a cross shape as a whole. The center coupling hole 243_3a1, into which the coupling member that couples the center body 271 to the hinge housing 150 inserted to be coupled thereto, may be disposed at a periphery of the center body 243_1 in the -x axis direction. A holding hole 243_3b1, in which the first elastic member 302a that supports the center bar 270 and the first holding member 301a are seated, may be disposed at a periphery of the center body 271 in the x axis direction. A first center wing part 243_2a and a second center wing part 243_2b, into which the first rotary shaft 231 and the second rotary shaft 232 is inserted to be fixed thereto, may be disposed in the peripheries of the center body 271 in the y axis or the y axis, respectively.

According to various embodiments, the center coupling hole 243_3a1 may be opened in the z axis direction and the -z axis direction. A coupling member (e.g., a screw) may be inserted into the center coupling hole 243_3a1. The coupling member may fix the center body 271 to the hinge housing 150 while being coupled to the boss formed in the hinge housing 150 through the center coupling hole 243_3a1.

According to various embodiments, the first center wing part 243_2a may be disposed at a periphery of a central area of the center body 243_1 in the -y axis direction, and may protrude from an upper surface of the center body 271 in the z axis direction. A first bracket hole 243_2a1 may be included at a center (e.g., a center that crosses the x axis and the -x axis) of the first center wing part 243_2a. The first center wing part 243_2a may have a circular band shape such that the first bracket hole 243_2a1 is formed at a central portion thereof. The first bracket hole 243_2a1 may be formed in a direction that is perpendicular to an opening direction of the center coupling hole 243_3a1. A size of the first bracket hole 243_2a1 may have a thickness that is the same as or similar to the thickness of the first rotary shaft 231. Alternatively, a shape (e.g., a circle) of the first bracket hole 243_2a1 may be different from a shape (e.g., a partial curve and a closed curve including a partial curve) of the first rotary shaft 231, and a diameter of the first bracket hole 243_2a1 may have a diameter that is larger than a diameter of the first rotary shaft 231.

According to various embodiments, the second center wing part 243_2b may be disposed at a periphery of a central area of the center body 243_1 in the y axis direction that is an opposite direction to the first center wing part 243_2a, and may protrude from an upper surface of the center body 271 in the z axis direction. The second center wing part 243_2b may include a second bracket hole 243_2b1 that crosses the x axis and the -x axis. The second bracket hole 243_2b1 may be disposed in parallel to the first bracket hole 243_2a1 with respect to the x axis. The second center wing part 243_2b may have a circular band shape such that the second bracket hole 243_2b1 is formed at a central portion thereof. The second bracket hole 243_2b1 may be opened in the same direction as that of the first bracket hole 243_2a1. The second bracket hole 243_2b1 may have the same size or shape as that of the first bracket hole 243_2a1. According to various embodiments, the second bracket hole 243_2b1 may have a shape that is different from a z axis cross-section (e.g., a cross-section taken from the z axis to the direction of the -z axis) of the second rotary shaft 232. The second rotary shaft 232 may be inserted into the second bracket hole 243_2b1, and the second rotary shaft 232 may be rotated in the second bracket hole 243_2b1.

The holding hole 243_3b1 may be formed to pass from the z axis to the -z axis. The first holding member 301a and the first elastic member 302a, for example, may be seated in the holding hole 243_3b1. In this regard, a size of the holding hole 243_3b1 may be the same as or larger than a size of one side of the first holding member 301a or the first elastic member 302a. The first holding member 301a may have an inverse T shape, and may be inserted into the holding hole 243_3b1 from -z axis to the direction of z axis. The first elastic member 302a may have a spring shape, and may support one side of the center bar 270 based on an elastic force after being coupled to a central portion of the first holding member 301a.

According to various embodiments, the shaft bracket 243b may have the same size and structure as those of the center bracket 243a. Accordingly, like or similarly to the center bracket 243a, the shaft bracket 243b may include a shaft body corresponding to the center body, a first shaft wing part corresponding to the first center wing part 243_2a, a second shaft wing part corresponding to the second center wing part 243_2b, a shaft coupling hole corresponding to the center coupling hole 243_3a1, and a hole corresponding to the holding hole 243_3b1.

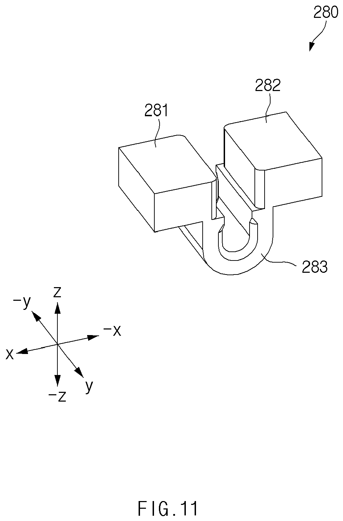

FIG. 11 is a view illustrating an example of the fixing ring according to various embodiments.

Referring to FIGS. 3 to 11, the fixing ring 280 according to an embodiment may include the first leg 281, the second leg 282, and a connection ring 283. The first leg 281 may have a rectangular shape, of which an upper surface in the z axis direction is flat and which has a specific thickness. The first leg 281 may be inserted into and fixed to the first ring connecting hole 274_1 of the ring connector 274. Like or similarly to the first leg 281, the second leg 282 may have a rectangular shape, of which an upper surface in the z axis direction is flat and which has a specific thickness. The first leg 281 and the second leg 282 may be disposed to be spaced apart from each other by a specific interval.

The connection ring 283 may have a U shape as a whole. One side of the connection ring 283 may be connected to a bottom end (e.g., a periphery of one side in the -z axis direction) of the first leg 281, and an opposite side of the connection ring 283 may be connected to a bottom end (e.g., a periphery of one side in the -z axis direction) of the second leg 282. The connection ring 283 may have a specific elasticity. According to an embodiment, an interval between one side and an opposite side of the connection ring 283, or an interval between the first leg 281 and the second leg 282 may be larger than an interval between the first ring connecting hole 274_1 and the second ring connecting hole 274_2 of the ring connector 274. Accordingly, when the fixing ring 280 is inserted into the ring connector 274, an elastic force may be exerted from a center of the connection ring 283 in an outward direction. At least a portion of the stabilizer 290 may be disposed at a center of the connection ring 283.

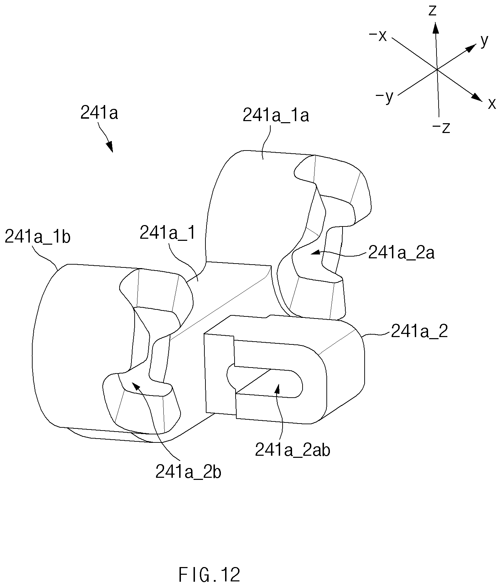

FIG. 12 is a view illustrating an example of the first cam member according to various embodiments. Prior to a description, the first cam member 241a illustrated in FIG. 12 may be the first cam member 241a disposed between the shaft bracket 243b and the center bracket 243a. In the following description, the first cam member 241a will be referenced.

Referring to FIGS. 3 to 12, the first cam member 241a may include a cam body 241a_1, a first cam 241a_1a, a second cam 241a_1b, a first cam hole 241a_2a and a second cam hole 241a_2b, a ring fixing part 241a_2, and a ring fixing hole 241a_2ab.

According to various embodiments, the cam body 241a_1 may have a bar shape, of which a length in the y axis and -y axis direction is larger than a length in the x axis direction. The first cam 241a_1a and the second cam 241a_1b may be disposed at opposite peripheries of the cam body 241a_1. The cam body 241a_1 may be disposed between the center body 243_1 of the center bracket 243a and a shaft bracket body 243b_3 of the shaft bracket 243b.

According to various embodiments, mountains and valleys may be disposed in the first cam 241a_1a in the x axis direction, and the first cam hole 241a_2a may be formed at a central portion thereof such that the first rotary shaft 231 passes therethrough. The first cam 241a_1a may be disposed to be engaged with one side (e.g., a cam of the first cam structure 221_4a in the -x axis direction) of the first cam structure 221_4a. One side of the first elastic body 242a may contact a surface of the first cam 241a_1a in the -x axis direction.

According to various embodiments, the second cam 241a_1b may be disposed in the same direction as that of the first cam 241a_1a, and may be disposed to be spaced apart from the first cam 241a_1a by a length of the cam body 241a_1 in the y axis. The second cam 241a_1b may be disposed to be engaged with one side (e.g., a cam of the third cam structure 222_4a in the -x axis direction) of the third cam structure 222_4a of the second arm part 222, and the second elastic body 242b may contact a surface of the second cam 241a_1b in the -x axis direction. The second cam hole 241a_2b may be formed at a central portion of the second cam 241a_1b such that the second rotary shaft 232 is inserted thereinto.

According to various embodiments, the first cam member 241a may be linearly moved rearwards in the -x axis direction by the first cam structure 221_4a and the second cam structure 222_4a while the first arm part 221 and the second arm part 222 are rotated in a specific angle range. In correspondence to additional rotation of the first arm part 221 or the second arm part 222, the first cam member 241a may be disposed to be engaged with the mountains and the valleys of the first cam structure 221_4a of the first arm part 221 and the third cam structure 222_4a of the second arm part 222, and in this process, may be moved in the x axis direction by the elasticity of the first elastic body 242a and the second elastic body 242b and return to an original location.

According to various embodiments, the ring fixing part 241a_2 may protrude from the cam body 241a_1 in the x axis direction. The ring fixing hole 241a_2ab that crosses the y axis and -y axis may be disposed at a center of the ring fixing part 241a_2. A length of the ring fixing hole 241a_2ab in the x axis direction may be larger than a length thereof in the z axis direction. One side of the stabilizer 290 may be disposed in the ring fixing hole 241a_2ab. At least a portion of the stabilizer 290 may be slid to the direction of the x axis or -x axis in the ring fixing hole 241a_2ab in correspondence to movement of the center bar 270 to the direction of the z axis or the -z axis.

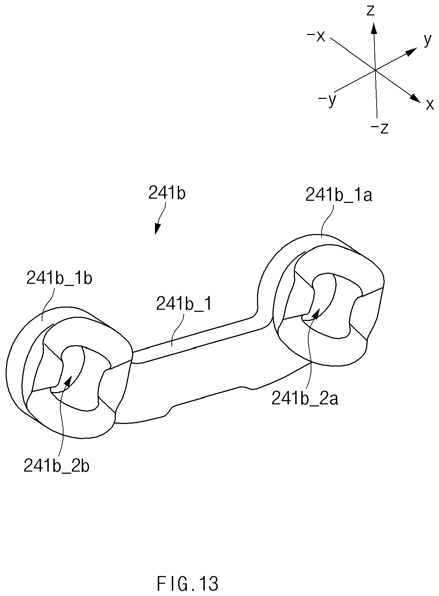

FIG. 13 is a view illustrating an example of the second cam member or the third cam member according to various embodiments. Prior to a description, in the following description, the second cam member 241b will be mainly described.

Referring to FIGS. 3 to 13, the second cam member 241b may include a cam body 241b_1, a third cam 241b_1a, a fourth cam 241b_1b, a third cam hole 241b_2a, and a fourth cam hole 241b_2b. The above-described configurations of the second cam member 241b may correspond to the configurations of the first cam member 241a described above in FIG. 12. For example, the cam body 241b_1 may correspond to the cam body 241a_1 of the first cam member 241a described in FIG. 12, the third cam 241b_1a may correspond to the first cam 241a_1a of the first cam member 241a, and the fourth cam 241b_1b may correspond to the second cam 241a_1b of the first cam member 241a. Furthermore, the third cam hole 241b_2a may correspond to the first cam hole 241a_2a of the first cam member 241a, and the fourth cam hole 241b_2a may correspond to the second cam hole 241a_2b of the first cam member 241a.

According to various embodiments, as mentioned above, the second cam member 241b illustrated in FIG. 13 may be the third cam member 241b. In this case, while the first cam 241a_1a of the first cam member 241a is disposed to be engaged with one side of the first cam structure 221_4a of the first arm part 221 and the second cam 241a_1b of the first cam member 241a is disposed to be engaged with the third cam structure 222_4a of the second arm part 222, the third cam 241b_1a of the second cam member 241b may be disposed to be engaged with an opposite side (e.g., the cam structure disposed in the x axis direction) of the first cam structure 221_4a of the first arm part 221 and the fourth cam 241b_1b of the second cam member 241b may be disposed to be engaged with the third cam structure 222_4b of the second arm part 222. In relation to a cam operation of the second cam member 241b, the third elastic body 242c and the fourth elastic body 242d may provide elastic forces to the second cam member 241b. Furthermore, among the cams of the third cam member 241c, a cam on one side may be disposed to be engaged with the second cam structure 221_4b of the first arm part 221, and a cam on an opposite side may be disposed to be engaged with the fourth cam structure 222_4b of the second arm part 222. In relation to a cam operation of the third cam member 241c, the fifth elastic body 242e and the sixth elastic body 242f may provide elastic forces to the third cam member 241c.

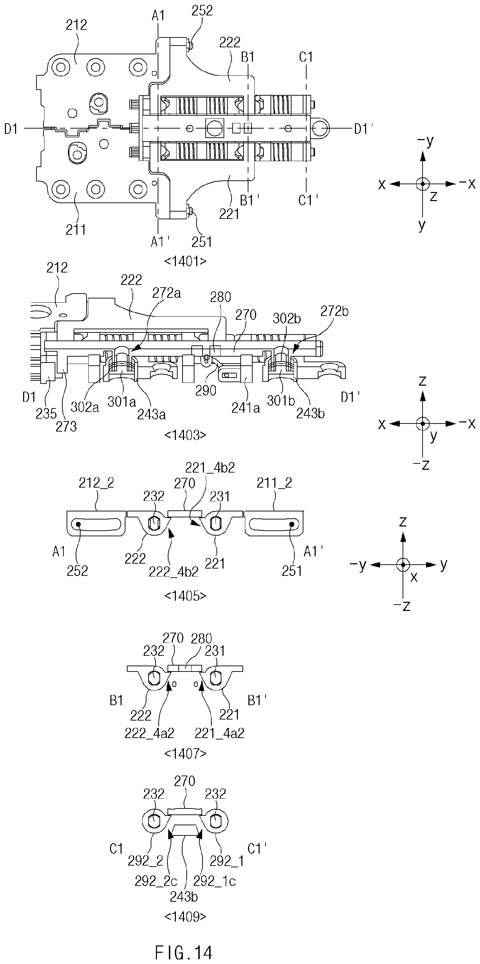

FIG. 14 is a view illustrating a first state of some configurations of the electronic device according to various embodiments. In FIG. 14, state 1401 corresponds to a view illustrating an unfolded state (e.g., a state, in which angle defined by the first rotation part 211 and the second rotation part 212 is about 180 degrees) of the first hinge structure 200a, and state 1403 corresponds to a view illustrating at least a portion of a cross-section obtained by cutting the first hinge structure 200a along cutting line D 1-D 1' in state 1401. State 1405 corresponds to a view illustrating an example of one cross-section of cutting line A1-A1' in state 1401, state 1407 corresponds to a view illustrating an example of one cross-section of cutting line B1-B1' in state 1401, and state 1409 corresponds to a view illustrating an example of one cross-section of cutting line C1-C1' in state 1401.

Referring to FIGS. 1A to 14, among the some configurations of the electronic device 100, the first hinge structure 200a may include at least the first rotation part 211, the second rotation part 212, the fixing bracket 213, the first arm part 221, the second arm part 222, the first rotary shaft 231, the second rotary shaft 232, the center bracket 243a, the first cam member 241a, the shaft bracket 243b, the center bar 270, the fixing ring 280, and the stabilizer 290. Additionally, the first elastic member 302a and the first holding member 301a may be disposed in the center bracket 243a, and the second elastic member 302b and the second holding member 301b may be disposed in the shaft bracket 243b. The first rotation part 211 may be connected to the first arm part 221 through the first coupling part 251. The second rotation part 212 may be connected to the second arm part 222 through the second coupling part 252. Additionally, the first hinge structure 200a may further include the second cam member 241b and the third cam member 241c, and the elastic bodies 242a, 242b, 242c, 242d, 242e, and 242f.

According to various embodiments, the display 160 may be maintained in the unfolded state while the first rotation part 211 and the second rotation part 212 are maintained in the unfolded state. The first arm part 221 may be rotated within a specific angle range (e.g., 0 degrees to 100 degrees or 0 degrees to 95 degrees) with respect to the first rotary shaft 231. The second arm part 222 may be rotated within a specific angle range with respect to the second rotary shaft 232.

According to various embodiments, an upper surface of the bracket body, which defines a first slide hole 211_2 of the first rotation part 211, an upper surface of a basic body of the first arm part 221, an upper surface of the center body 271, an upper surface of a basic body of the second arm part 222, and an upper surface of the bracket body, which defines the slide hole 212_2 of the second rotation part 212, may be disposed at the same height. As described above, because the heights of the upper surfaces (e.g., the surfaces that face the z axis direction) of the first rotation part 211, the first arm part 221, the center bar 270, the second arm part 222, and the second rotation part 212 are maintained at the same height, the rear surface of the display 160 may be supported uniformly. When the first hinge structure 200a is in an unfolding operation, the first coupling part 251 may be located at a periphery of the first slide hole 211_2 in the y axis and the second coupling part 252 may be located at a periphery of the second slide hole 212_2 in the -y axis.

An opposite side of the stabilizer 290, to which one side of the fixing ring 280 is coupled, may be coupled to the ring fixing hole 241a_2ab of the ring fixing part 241a_2 provided in the first cam member 241a. An opposite side of the stabilizer 290 may be located at a periphery of the ring fixing hole 241a_2ab in the -y axis (or a sliding hole or a slot hole, through which the stabilizer 290 may be moved in the y axis direction) when the first hinge structure 200a is in the unfolded state. The first support ring 292_1 inserted into the first rotary shaft 231 and the second support ring 292_2 inserted into the second rotary shaft 232 may be disposed to support a periphery of one side of the center bar 270.

As described above, when the first hinge structure 200a is in the unfolded state, holding parts (e.g., 221_4a2, 221_4b2, 222_4a2, and 222_4b2) formed in the first cam structure 221_4a and the second cam structure 221_4b of the first arm part 221 and the third cam structure 222_4a and the fourth cam structure 222_4b of the second arm part 222 may be disposed to support a periphery of the center bar 270 in the y axis or the -y axis, and a periphery of the center bar 270 in the y axis or the -y axis may be supported by the support bosses 292_1c and 292_2c formed in the first support ring 292_1 and the second support ring 292_2, respectively. In this operation, the stabilizer 290 disposed in the fixing ring 280 may maintain a balance of the center bar 270, the first elastic member 302a and the second elastic member 302b may support the first center boss 272a and the second center boss 272b of the center bar 270, and the third center boss 273 may be guided by the stopper 235. Based on the above-described structure, the center bar 270 may be disposed while stably establishing equilibrium with respect to the x-y plane in the unfolded state of the first hinge structure 200a.

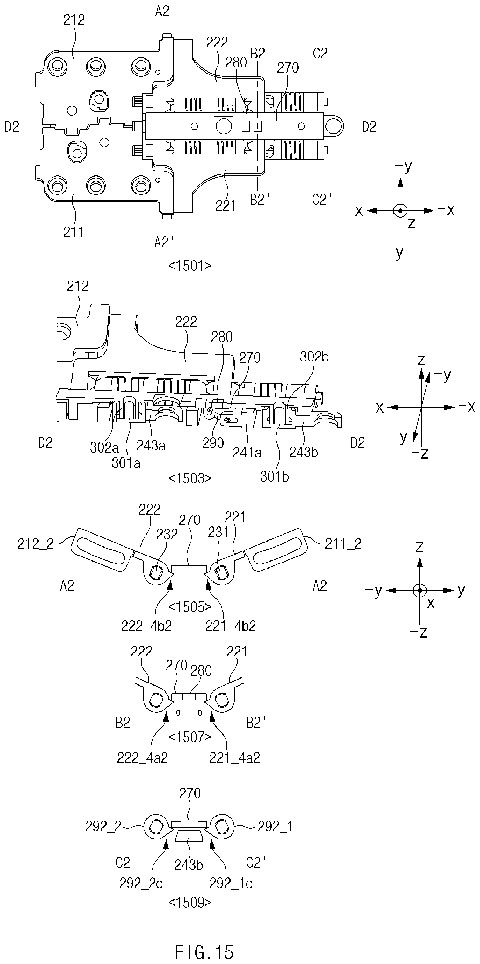

FIG. 15 is a view illustrating a first angle state of some structures of the electronic device according to various embodiments. In FIG. 15, state 1501 corresponds to a view illustrating a folded state (e.g., a state, in which angle defined by the first rotation part 211 and the second rotation part 212 is smaller than 180 degrees, for example, a state of about 120 degrees) of the first hinge structure 200a, and state 1503 corresponds to a view illustrating at least a portion of a cross-section obtained by cutting the first hinge structure 200a along cutting line D2-D2' in state 1501. State 1505 corresponds to a view illustrating an example of one cross-section of cutting line A2-A2' in state 1501, state 1507 corresponds to a view illustrating an example of one cross-section of cutting line B2-B2' in state 1501, and state 1509 corresponds to a view illustrating an example of one cross-section of cutting line C2-C2' in state 1501.

Referring to FIGS. 1A to 15, the first hinge structure 200a (or the second hinge structure 200b) may include a first angle state (e.g., a state, in which an angle between the upper surfaces (surfaces in the z axis direction) of the first rotation part 211 and the second rotation part 212 and the horizontal axis (the y axis) is 30 degrees). As described above, the first hinge structure 200a may include at least the first rotation part 211, the second rotation part 212, the fixing bracket 213, the first arm part 221, the second arm part 222, the first rotary shaft 231, the second rotary shaft 232, the center bracket 243a, the first cam member 241a, the shaft bracket 243b, the center bar 270, the fixing ring 280, and the stabilizer 290. Additionally, the first elastic member 302a and the first holding member 301a may be disposed in the center bracket 243a, and the second elastic member 302b and the second holding member 301b may be disposed in the shaft bracket 243b.

According to various embodiments, in correspondence to an external pressure, the rail of the first rotation part 211 may be rotated by a specific angle in the counterclockwise direction (or the clockwise direction) along the first rail groove of the fixing bracket 213, and the rail of the second rotation part 212 may be rotated by a specific angle in the clockwise direction (or the counterclockwise direction) along the second rail groove of the fixing bracket 213. During the rotation thereof while an angle between the first rotation part 211 and the second rotation part 212 is a first angle, a central portion of the display 160 also may be in a folded state at a specific angle (e.g., the first angle).

According to various embodiments, while the first arm part 221 and the second arm part 222 are rotated by a specific angle in the counterclockwise direction and the clockwise direction, the holding parts (e.g., 221_4a2, 221_4b2, 222_4a2, and 222_4b2) disposed in the first arm part 221 and the second arm part 222 may be rotated to face the -z axis direction. In the same way or similarly, the first support boss 292_1c formed in the first support ring 292_1 and the second support boss 292_2c formed in the second support ring 292_2 also may be rotated in the -z axis direction in correspondence to rotation of the first rotary shaft 231 in the counterclockwise direction and rotation of the second rotary shaft 232 in the clockwise direction. While a central portion of the display 160 is folded at the first angle, the center bar 270 may be lowered in the -z axis direction while being maintained in parallel to the x-y plane by the fixing ring 280 and the stabilizer 290 connected to the fixing ring 280, the first elastic member 302a and the first holding member 301a disposed in the center bracket 243a, and the second elastic member 302b and the second holding member 301b disposed in the shaft bracket 243b. Accordingly, opposite peripheries of the center bar 270 may be supported by the holding parts 221_4a2, 221_4b2, 222_4a2, and 222_4b2 and the support bosses 292_1c and 292_2c.

According to various embodiments, as the center bar 270 is lowered in the -z axis direction, an opposite side (a part located in the ring fixing hole 241a_2ab) of the stabilizer 290 connected to the fixing ring 280 may be moved in the ring fixing hole 241a_2ab formed in the first cam member 241a. For example, an opposite side of the stabilizer 290 may be moved from an x axis periphery of the ring fixing hole 241a_2ab by a specific distance in the -x axis direction.

As described above, when the first hinge structure 200a is in the folded state at the first angle, the periphery of the center bar 270 in the y axis or -y axis may be supported by the holding parts (e.g., 221_4a2, 221_4b2, 222_4a2, and 222_4b2) formed in the first cam structure 221_4a and the second cam structure 221_4b of the first arm part 221 and the third cam structure 222_4a and the fourth cam structure 222_4b of the second arm part 222 and the bosses 292_1c and 292_2c formed in the first support ring 292_1 and the second support ring 292_2 even when the center bar 270 is lowered in the -z axis direction. Accordingly, the center bar 270 may be lowered in the -z axis direction while being in parallel to the x-y plane while not being inclined in a specific direction.

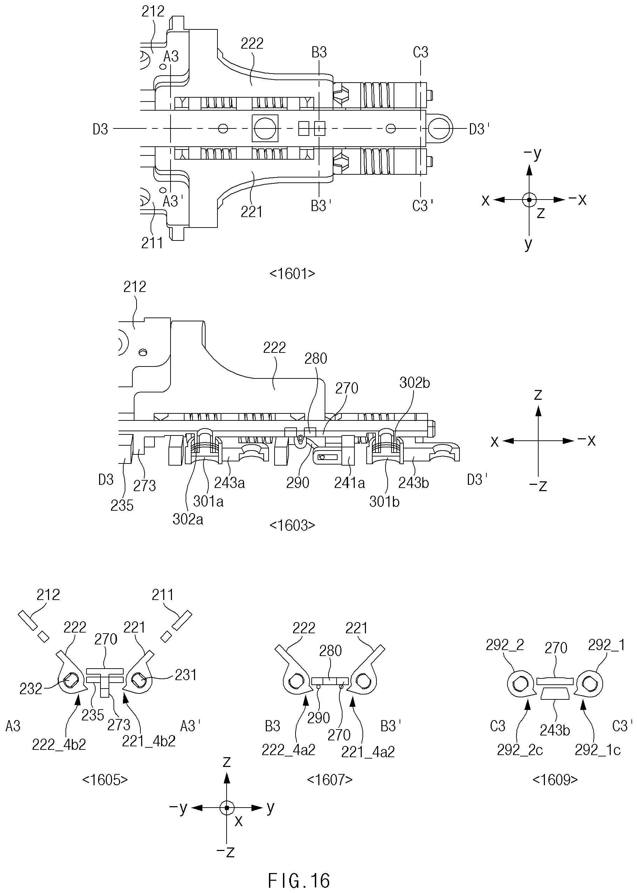

FIG. 16 is a view illustrating the second angle state of some structures of the electronic device according to various embodiments. In FIG. 16, state 1601 corresponds to a view illustrating a second angle state (e.g., a state, in which angle defined by the first rotation part 211 and the second rotation part 212 is smaller than 120 degrees, for example, a state of about 60 degrees) of the first hinge structure 200a, and state 1603 corresponds to a view illustrating at least a portion of a cross-section obtained by cutting the first hinge structure 200a along cutting line D3-D3' in state 1601. State 1605 corresponds to a view illustrating an example of one cross-section of cutting line A3-A3' in state 1601, state 1607 corresponds to a view illustrating an example of one cross-section of cutting line B3-B3' in state 1601, and state 1609 corresponds to a view illustrating an example of one cross-section of cutting line C3-C3' in state 1601.

Referring to FIGS. 1A to 16, the first hinge structure 200a (or the second hinge structure 200b) may include a second angle state (e.g., a state, in which an angle between the upper surfaces (surfaces in the z axis direction) of the first rotation part 211 and the second rotation part 212 and the horizontal axis (the y axis) is 60 degrees). The hinge structure 200a may include at least the first rotation part 211, the second rotation part 212, the fixing bracket 213, the first arm part 221, the second arm part 222, the first rotary shaft 231, the second rotary shaft 232, the center bracket 243a, the first cam member 241a, the shaft bracket 243b, the center bar 270, the fixing ring 280, and the stabilizer 290. Additionally, the first elastic member 302a and the first holding member 301a may be disposed in the center bracket 243a, and the second elastic member 302b and the second holding member 301b may be disposed in the shaft bracket 243b.

According to various embodiments, in correspondence to an external pressure, the first rotation part 211 may be rotated by a specific angle (e.g., an angle that is larger than the angle described in FIG. 15) in the counterclockwise direction, and the second rotation part 212 may be rotated by a specific angle (e.g., an angle that is larger than the angle described in FIG. 15) in the clockwise direction. During rotation while an angle between the first rotation part 211 and the second rotation part 212 is a second angle, a central portion of the display 160 also may be in a folded state at a specific angle (e.g., the second angle).

According to various embodiments, while the first arm part 221 and the second arm part 222 are rotated by a specific angle in the counterclockwise direction and the clockwise direction in correspondence to the rotation of the first rotation part 211 and the rotation of the second rotation part 212, the holding parts (e.g., 221_4a2, 221_4b2, 222_4a2, and 222_4b2) disposed in the first arm part 221 and the second arm part 222 may be rotated to face the -z axis direction. Accordingly, the holding parts 221_4a2, 221_4b2, 222_4a2, and 222_4b2 may be in a non-contact state with the center bar 270. In the same way or similarly, the first support boss 292_1c formed in the first support ring 292_1 and the second support boss 292_2c formed in the second support ring 292_2 also may be rotated in the -z axis direction in correspondence to rotation of the first rotary shaft 231 in the counterclockwise direction and rotation of the second rotary shaft 232 in the clockwise direction whereby they may be in a non-contact state with the center bar 270. While the first hinge structure 200a is folded at the second angle, the center bar 270 may be lowered in the -z axis direction by the stabilizer 290 connected to the fixing ring 280 while being supported by the first elastic member 302a and the first holding member 301a disposed in the center bracket 243a, and the second elastic member 302b and the second holding member 301b disposed in the shaft bracket 243b.

As described above, because the center bar 270 is lowered while the center bar 270 is supported by the first elastic member 302a and the second elastic member 302b coupled to the first center boss 272a and the second center boss 272b of the center bar 270 even though the center bar 270 is lowered in the -z axis direction while the first hinge structure 200a is folded at the second angle, the center bar 270 may be lowered in the -z axis direction while being parallel to the x-y plane with no inclination in a specific direction.

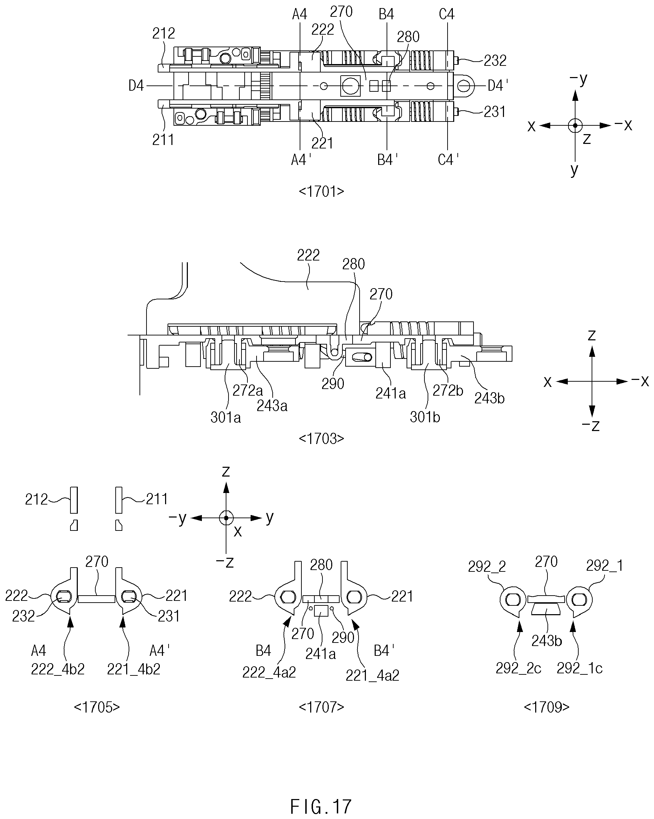

FIG. 17 is a view illustrating the second state of some structures of the electronic device according to various embodiments. In FIG. 17, state 1701 corresponds to a view illustrating a second state (e.g., a state, in which angle defined by the first rotation part 211 and the second rotation part 212 is about 90 degrees) of the first hinge structure 200a, and state 1703 corresponds to a view illustrating at least a portion of a cross-section obtained by cutting the first hinge structure 200a along cutting line D4-D4' in state 1701. State 1705 corresponds to a view illustrating an example of one cross-section of cutting line A4-A4' in state 1701, state 1707 corresponds to a view illustrating an example of one cross-section of cutting line B4-B4' in state 1701, and state 1709 corresponds to a view illustrating an example of one cross-section of cutting line C4-C4' in state 1701.

Referring to FIGS. 1A to 17, the electronic device 100 may include the first hinge structure 200a and the display 160. The second state of the first hinge structure 200a may be the folded state. The first hinge structure 200a, for example, may include at least the fixing bracket 213, the first rotation part 211, the second rotation part 212, the first arm part 221, the second arm part 222, the first rotary shaft 231, the second rotary shaft 232, the center bracket 243a, the first cam member 241a, and the shaft bracket 243b.

According to an embodiment, when the first rotation part 211 and the second rotation part 212 are rotated in the counterclockwise direction and the clockwise direction, respectively, to be disposed to be parallel to each other, the first rotation part 211 and the second rotation part 212 may be disposed to face each other. The first rotation part 211 may be disposed to be parallel to a vertical axis (e.g., the z axis), or may be disposed to be inclined further by a specific angle in the -y axis direction with respect to the vertical axis (e.g., the z axis). According to various embodiments, similarly to the first rotation part 211, the second rotation part 212 may be disposed to be parallel to the vertical axis (e.g., the z axis), or may be inclined further by a specific angle in the y axis direction with respect to the vertical axis (e.g., the z axis). The first arm part 221 may be rotated about the first rotary shaft 231 to be disposed in parallel to the first rotation part 211, and the second arm part 222 may be rotated about the second rotary shaft 232 to be disposed in parallel to the second rotation part 212. Accordingly, the central portion 163 of the display 160 may be curved in a "U" shape, and the remaining areas thereof may be maintained in the flat state.

According to various embodiments, while the first rotation part 211 and the first arm part 221 are disposed perpendicularly to each other (or to be inclined by a specific angle in the -y axis direction with respect to the vertical axis (e.g., z axis)), the upper surface of the first rotation part 211 and the upper surface of the first arm part 221 may be disposed in parallel to each other with no height difference. Similarly, while the second rotation part 212 and the second arm part 222 are disposed perpendicularly to each other (or to be inclined by a specific angle in the y axis direction with respect to the vertical axis (e.g., the z axis)), the upper surface of the second rotation part 212 and the upper surface of the second arm part 222 may be disposed in parallel to each other with no height difference.

According to various embodiments, when the display 160 of the electronic device 100 is in the folded state (e.g., a state, in which a central portion of the display 160 is deformed to a U shape), the first arm part 221 is disposed to be parallel to the z axis whereby the holding parts 221_4a2 and 221_4b2 located at an end of the first arm part 221 may be disposed to face the -z axis direction. Similarly, because the second arm part 221 is disposed in parallel to the z axis, the holding parts 222_4a2 and 222_4b2 located at an end of the second arm part 222 may be disposed to face the -z axis direction.

The center bar 270 may be disposed between the first arm part 221 and the second arm part 222. According to an embodiment, one side of the center bar 270 may be supported by the first elastic member 302a and the first holding member 301a, and an opposite side thereof may be supported by the second elastic member 302b and the second holding member 301b. The stabilizer 290 may be connected to the central portion of the center bar 270 through the fixing ring 280. A portion of the stabilizer 290 may be coupled to the ring connector 274 provided in the first rotation part 211. Because the center bar 270 is lowered in the -z axis direction in the second state (e.g., the fully folded state) of the first hinge structure 200a, a portion of the stabilizer 290 may be disposed at a -x axis periphery of the ring fixing hole 241a_2ab to be biased.

As described above, because the center bar 270 is supported by the first elastic member 302a and the second elastic member 302b coupled to the first center boss 272a and the second center boss 272b of the center bar 270 even though the center bar 270 is not supported by the holding parts 221_4a2, 221_4b2, 222_4a2, and 222_4b2 and the support bosses 292_1c and 292_2c while the center bar 270 is lowered in the -z axis direction while the first hinge structure 200a is folded at the second angle, the center bar 270 may be lowered in the -z axis direction while being parallel to the x-y plane with no inclination in a specific direction even though the center bar 270 is lowered in the -z axis direction.

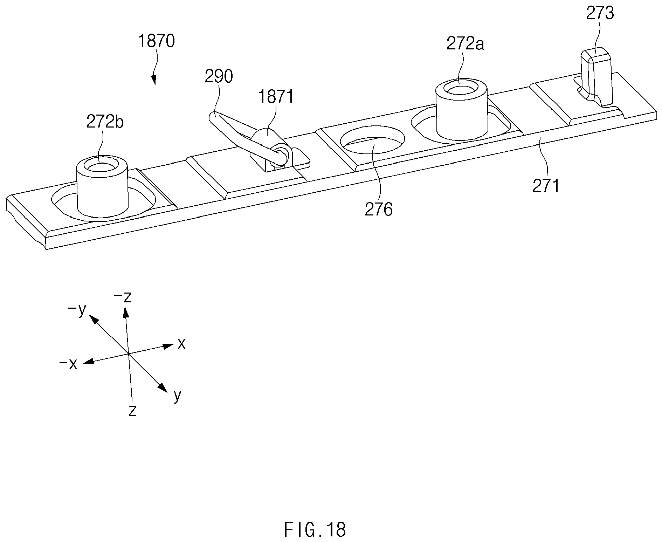

FIG. 18 is a view illustrating an example of another form of the center bar according to various embodiments.

Referring to FIGS. 9 and 18, a center bar 1870 according to an embodiment may include the center body 271, the first center boss 272a, the second center boss 272b, the third center boss 273, and the opening 276, and additionally, an integral fixing ring 1871, to which the stabilizer 290 is coupled, may be disposed to be integral with the center body 271.

A length of the center body 271 in the x axis direction may be larger than a length thereof in the y axis direction, and may have a specific thickness in the z axis direction. According to an embodiment, the center body 271 may have a panel shape that is formed long in the x axis direction. The center body 271 may be formed of a material having a specific strength to support one side of the display 160, for example, a metallic material. A surface of the center body 271 in the -z axis direction may be formed to be flat in relation of support of the central portion of the display 160.

The first center boss 272a may have a size and a structure that are the same as or similar to those of the first center boss 272a described above in FIG. 9. Referring to FIGS. 9 and 18, at least a portion of the first holding member 301a may be inserted into the first center boss 272a, and the first elastic member 302a may be inserted into an outside of the first center boss 272a. The first elastic member 302a, the first holding member 301a, and the first center boss 272a may be inserted into the hole formed in the center bracket 243a.

The second center boss 272b may have a size and a structure that are the same as or similar to those of the second center boss 272b described above in FIG. 9. Referring to FIGS. 9 and 18, at least a portion of the second holding member 301b may be inserted into the second center boss 272b, and the second elastic member 302b may be inserted into an outside of the second center boss 272b. The second elastic member 302b, the second holding member 301b, and the second center boss 272b may be inserted into the hole formed in the shaft bracket 243b.

Like or similarly to the third center boss 273 described above in FIG. 9, the third center boss 273 may be disposed between one side of the stopper 235 and the third cam member 241c to guide movement of the center bar 1870 in the z axis or -z axis direction.

The integral fixing ring 1871 may be formed to be integral with one side of the center body 271. The integral fixing ring 1871 may protrude from a surface of the center body 271 in the -z axis direction, to the -z axis direction. The integral fixing ring 1871 may have a hole or a recess that crosses from the -y axis to the y axis. According to various embodiments, although it has been exemplified in the drawings illustrating the integral fixing ring 1871 that a central portion thereof includes a hole that passes in the y axis direction, but the disclosure is not limited thereto. For example, the integral fixing ring 1871 may have a structure, by which one side of the stabilizer 290 may be fixed, for example, a hook shape. Then, a width of the recess, into which the stabilizer 290 is inserted, may be smaller than a thickness of the stabilizer 290 such that separation of the stabilizer 290 is prevented. The stabilizer 290 may be inserted into and coupled to the integral fixing ring 1871 in a hook form through an interference-fitting scheme through the recess. When the integral fixing ring 1871 has a hole shape that crosses the y axis as illustrated, a gap (e.g., the gap of FIG. 4) may be formed on one side of the stabilizer 290, and the stabilizer 290 may be inserted into the hole of the integral fixing ring through the gap. A portion of the stabilizer 290 may be inserted into the ring fixing hole 241a_2ab of the first cam member 241a descried above in FIG. 12.

When the integral fixing ring 1871 is applied to the center bar 1870, the above-described fixing ring 280 and the ring connector 274 for coupling the fixing ring 280 to the center bar 1870 may be omitted and may be replaced by the integral fixing ring 1871.

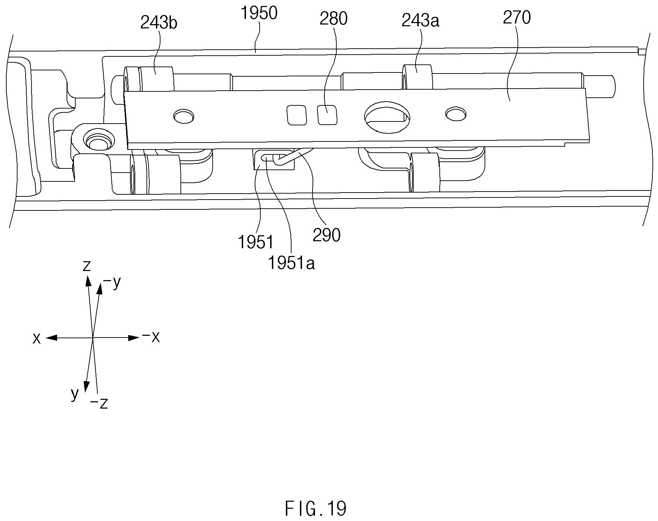

FIG. 19 is a view illustrating an example of another form of the electronic device according to various embodiments.

Referring to FIGS. 1A to 19, the electronic device 100 may include at least a hinge housing 1950 and a hinge structure (e.g., include at least the center bracket 243a, the shaft bracket 243b, the center bar 270, the fixing ring 280, and the stabilizer 290).

According to various embodiments, the electronic device 100, for example, may include the display 160, the first housing 110, the second housing 120, and a hinge structure that connects the first housing 110 and the second housing 120 and at least a portion of which is seated on the hinge housing 1950. For example, as described above in FIGS. 2 to 13, the center bar 270 of the hinge structure may include the fixing ring 280 connected to the center body 271 and the stabilizer 290 connected to the fixing ring 280. According to various embodiments, as described in FIG. 18, the center bar 270 may have a structure of the center bar 1870, in which the stabilizer 290 is coupled to the integrally formed fixing ring 280.

The hinge housing 1950 may have a structure, in which at least a portion of the hinge structure may be seated thereon and fixed thereto. According to an embodiment, the hinge housing 1950 may include a bar connector 1951 that protrudes from one side of a bottom surface of the hinge housing 1950 in the z axis direction. The bar connector 1951 may have a bar connecting hole 1951a that crosses the y axis and the -y axis. The bar connecting hole 1951a may be formed long in the x axis direction. Accordingly, the stabilizer 290 coupled to the bar connecting hole 1951a may be linearly moved in the x axis or -x axis direction as the center bar 270 is moved in the z axis or -z axis direction inside the bar connecting hole 1951a.

When the bar connector 1951 is integrally formed with the above-described hinge housing 1950, the structure of the first cam member 241a described above in FIG. 12 may be the same as the structures of the second cam member 241b and the third cam member 241c.

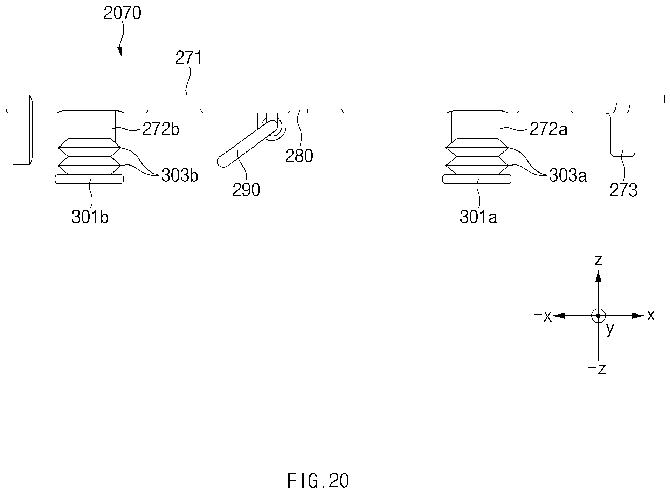

FIG. 20 is a view illustrating an example of another form of the electronic device according to various embodiments.

Referring to FIGS. 1A to 20, the electronic device 100 may include at least a center bar 2070, the fixing ring 280, the stabilizer 290, the first holding member 301a, the second holding member 301b, a third elastic member 303a, and a fourth elastic member 303b.

According to various embodiments, the electronic device 100, for example, may include the display 160, the first housing 110, the second housing 120, and a hinge structure (e.g., the first hinge structure 200a and the second hinge structure 200b) that connects the first housing 110 and the second housing 120 and at least a portion of which is seated on the hinge housing (e.g., the hinge housing 150 described in FIG. 1A). For example, as described above in FIGS. 2 to 13, the center bar 2070 of the first hinge structure 200a may include the fixing ring 280 connected to the center body 271 and the stabilizer 290 connected to the fixing ring 280. According to various embodiments, as described in FIG. 18, the center bar 2070 may have the center bar 1870, in which the stabilizer 290 is coupled to the integrally fixing ring 1871. Furthermore, according to various embodiments, as described in FIG. 19, the ring connector 241a_2a (e.g., the ring connector formed in the first cam member 241a), to which a portion of the stabilizer 290 is coupled, may be replaced by the bar connector 1951 disposed in the hinge housing 150.

The center bar 1870 may include the center body 271, the first center boss 272a, the second center boss 272b, and the third center boss 273.

A length of the center body 271 in the x axis direction may be larger than a length thereof in the y axis direction, and may have a specific thickness in the z axis direction. According to an embodiment, the center body 271 may have a panel shape that is formed long in the x axis direction. The center body 271 may be formed of a material having a specific strength to support one side of the display 160, for example, a metallic material. A surface of the center body 271 in the -z axis direction may be formed to be flat in relation of support of the central portion of the display 160. The fixing ring 280 and the stabilizer 290 coupled to the fixing ring 280 may be disposed at the central portion of the center body 271.

The first center boss 272a, for example, may be disposed to be closer to the third center boss 273 than the second center boss 272b. Alternatively, the first center boss 272a may be disposed between the stabilizer 290 and the third center boss 273. The first center boss 272a may have a cylindrical shape having an empty space therein such that at least a portion of the first holding member 301a is inserted thereinto, and may extend from a surface of the center body 271 in the -z axis direction, in the -z axis direction. The third elastic member 303a may be disposed at an end of the first center boss 272a in the -z axis direction. According to an embodiment, a specific interval may be formed between an end of the first center boss 272a in the -z axis and an end of the first holding member 301a in the -z axis, and the third elastic member 303a may be disposed in the interval.

The third elastic member 303a may include a plurality of leaf springs. The leaf springs may have a shape, a central portion of which has a hole that passes in the z axis direction and which is convex in one direction. According to various embodiments, the third elastic member 303a may include a plurality of leaf springs disposed such that the convex parts thereof face each other. Alternatively, the third elastic member 303a may have a structure, which has one leaf spring, includes at least one wrinkle that has elasticity, and has a hole that passes in the z axis direction at a central portion thereof. The third elastic member 303a may be inserted into and fixed to the first holding member 301a, and may contact the first center boss 272a in the z axis direction.

The second center boss 272b, for example, may be disposed at a periphery of the center body 271 in the -x axis direction. Similarly to the first center boss 272a, the second center boss 272b may have a cylindrical shape that has an empty space therein such that at least a portion of the second holding member 301b is inserted thereinto, and may extend from a surface (e.g., a rear surface of the center body 271) of the center body 271 in the -z axis direction, in the -z axis direction (e.g., the direction of the rear surface). The fourth elastic member 303b may be disposed at an end of the second center boss 272b in the -z axis direction. According to an embodiment, a specific interval may be formed between an end of the second center boss 272b in the -z axis and an end of the second holding member 301b in the -z axis, and the fourth elastic member 303b may be disposed in the interval. Like the third elastic member 303a described above, the fourth elastic member 303b may have a hole that passes in the z axis direction, may have at least one wrinkle that exerts an elastic force, or may be formed by superimposing the plurality of leaf springs. One side of the fourth elastic member 303b may be inserted into the fourth elastic member 303b, and the fourth elastic member 303b may be disposed to support the second center boss 272b.

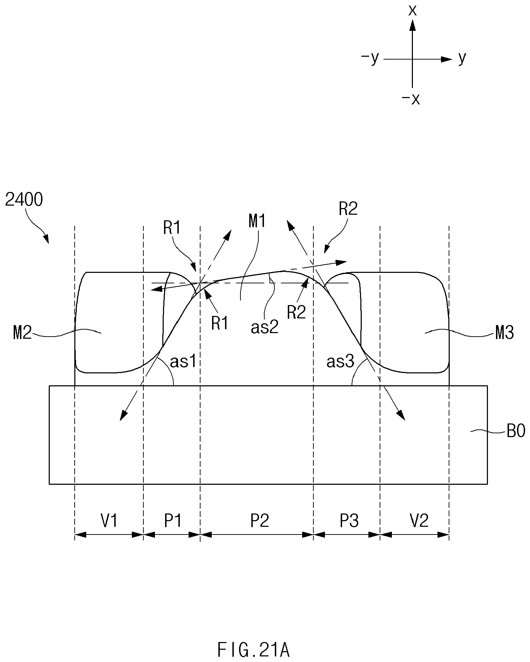

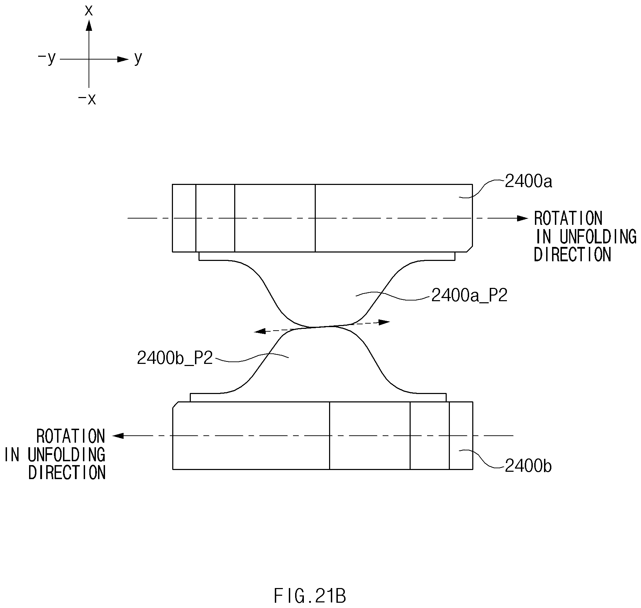

FIG. 21A is a view illustrating another example of a shape of the cam according to various embodiments. FIG. 21B is a view illustrating an example of a contact state of some mountains from the cam and the cam structure according to various embodiments. Prior to a description, a cam 2400a according to an embodiment may be applied to at least one of the cam of the cam member or the cam structure of the arm part described above in FIGS. 2 to 17.

Referring to FIG. 21A, the cam 2400a (or the cam structure) according to the embodiment may include a cam support portion B0, a plurality of mountains M1, M2, and M3, and a plurality of valleys V1 and V2. Although the illustrated drawings suggest the cam 2400a including three mountains M1, M2, and M3 and three valleys V1 and V2 (a valley covered by the first mountain M1 is not illustrated), the disclosure is not limited thereto. For example, the cam 2400a may have a structure including two or more cams and valleys. All of the plurality of mountains M1, M2, and M3 may have the same structure. Furthermore, at least one mountain of the plurality of mountains M1, M2, and M3 may have different forms from those of the other mountains. For example, as illustrated, at least one mountain may have a structure, in which a second part P2 corresponding to the center of the mountain has a specific inclination angle (e.g., an inclination angle that is larger than 0, for example, around about 5 degrees), and at least one of the remaining mountains may have a structure, in which a central portion of the mountain is flat.

According to an embodiment, at least one mountain of the plurality of mountains M1, M2, and M3, for example, the first mountain M1, as illustrated, may include a first part P1 having a first inclination angle as1, the second part P2 having a second inclination angle as2, and a third part P3 having a third inclination angle as3. One side (e.g., an end as seen along the -y axis) of the first part P1 is connected to one side (e.g., an end as seen along the y axis) of the first valley V1, and an opposite side (e.g., an end as seen along the y axis) of the first part P1 may be connected to one side (e.g., an end as seen along the -y axis) of the second part P2. The first part P1, for example, may have a ridge line having the first inclination angle as1 with respect to the y axis. The first inclination angle as1 may include an acute angle that is smaller than 90 degrees from the - y axis to the y axis direction with respect to the x axis.

One side (e.g., an end as seen along the -y axis) of the second part P2 is connected to an opposite side (e.g., an end as seen along the y axis) of the first part P1, and an opposite side (e.g., an end as seen along the y axis) of the second part P2 may be connected to one side (e.g., an end as seen along the -y axis) of the third part P3. The second part P2 may be disposed to protrude further than the first part P1 and the third part P3 in the x axis direction. A border area of the first part P1 and the second part P2 may be rounded at a specified first curvature R1. The second part P2 may have the second inclination angle as2 with respect to the y axis. The second inclination angle as2 may include an acute angle that is smaller than 90 degrees from the -y axis in the y axis direction with respect to the x axis, and an absolute value of the second inclination angle as2 may be smaller than an absolute value of the first inclination angle as1.

One side (e.g., an end seen along the -y axis) of the third part P3 may be connected to an opposite side (e.g., an end seen along the y axis) of the second part P2, and an opposite side (e.g., an end seen along the y axis) of the third part P3 may be connected to one side (e.g., an end seen along the -y axis) of the second valley V2. The third part P3 may be formed to have a specific inclination that is inclined from the second part P2 in the y axis direction. A border area of the second part P2 and the third part P3 may be rounded at a specified second curvature R2. The second curvature R2 may have a value (e.g., the first curvature R1 is smoother than the second curvature R2) that is smaller than the first curvature R1. The third part P3 may have the third inclination angle as3 with respect to the -y axis. The third inclination angle as3 may include an acute angle that is smaller than 90 degrees from the -y axis in the y axis direction with respect to the x axis, and an absolute value of the third inclination angle as3 may be larger than an absolute value of the second inclination angle as2. According to various embodiments, an absolute value of the third inclination angle as3 may be the same as or larger than the absolute value of the first inclination angle as1.

Referring to FIG. 21B, the cam shape described in FIG. 21A may be applied to the a cam of the at least one cam member or a cam structure of the at least one arm part described above in FIGS. 2 to 20. For example, in the illustrated drawings, a protrusion of the cam 2400a may be disposed to protrude from the x axis in the -x axis direction, and a protrusion of a cam structure 2400b may be disposed to protrude from the -x axis in the x axis direction. Furthermore, a convexo-concave part of the cam 2400a and a convexo-concave part of the cam structure 2400b may be disposed to face each other. At least a portion of the second part 2400a_P2 of the cam 2400a and at least a portion of the second part 2400b_P2 of the cam structure 2400b, as illustrated, may contact each other in a free-stop section (a section, in which the electronic device is held at a specific angle range due to the friction of the cam 2400a and the cam structure 2400b) of the electronic device (e.g., the electronic device 100 of FIG. 2). According to an embodiment, when the electronic device is in the free-stop state described in FIG. 15 or 16, a repulsive force for restoring the display (the display 160 of FIG. 1 or 2) to the unfolding state (the state of FIG. 14) may be shown.

According to an embodiment, the cam 2400a may be pushed in the y axis direction by a restoring force of the display (e.g., a repulsive force of the display is applied in the counter clockwise direction), and the cam structure 2400b may be pushed in the -y axis direction by a restoring force of the display (e.g., a repulsive force of the display is applied in the clockwise direction). In this process, because the second part 2400a_P2 of the cam 2400a and the second part 2400b_P2 of the cam structure 2400b contact each other while having the above-described second inclination angle as2, the cam 2400a and the cam structure 2400b of the disclosure may restrain pushing (e.g., an angle between the first housing (e.g., the first housing 110 of FIG. 1A) and the second housing (e.g., the second housing 120 of FIG. 1A) in the free-stop state, which may occur regardless of an intention of the user by offsetting at least a portion of the repulsive force (or the restoring force) generated in the unfolding direction of the display. According to various embodiments, as described above in FIG. 15 or 16, the electronic device may be in a holding state (or a free-stop state) of a specific angle. In this case, the electronic device, as illustrated, may be disposed such that the cam 2400a and the cam structure 2400b are engaged with each other, and may offset a force, by which the repulsive force or the restoring force of the display is applied in the unfolded state as in FIG. 14. Although FIG. 21B exemplifies a structure, in which apex portions of the mountains of both of the cam 2400a and the cam structure 2400b have the second inclination angle as2, the disclosure is not limited thereto. For example, the second part P2 having the second inclination angle as2 may be formed in any one of the cam 2400a or the cam structure 2400b.

Meanwhile, although FIG. 21B is illustrated with respect to a direction, in which the cam 2400a is rotated from the -y axis (or the left side) in the y axis (or rightward) direction, the disclosure is not limited thereto. For example, according to a design layout of the electronic device, a direction, in which the cam 2400a is rotated from the y axis in the -y axis direction, may be a direction, in which the display is operated in the unfolded state, from the folded state.

Meanwhile, the configurations described above in FIGS. 1A to 21B may be selectively singular or plural. For example, although the fixing ring has a structure including two legs, it may include one leg, and in this case, the connection ring may have a ring shape, one side of which is opened, or may have a ring shape including a hole that passes in the y axis direction. Furthermore, according to various embodiments, although it has been exemplified that the first center boss 272a has a structure having a cylindrical shape having an empty interior and the first holding member 301a, to which the first elastic member 302a is coupled, is inserted into the first center boss 272a, the above-described structure may have a structure, in which an empty space is formed inside the first holding member and the first elastic member, after being coupled to the first center boss, is inserted into the first holding member. Furthermore, although it has been exemplified that the center bar 270 has a structure including three center bosses, the center bar 270 of the disclosure may include only one center boss (e.g., the second center boss 272b) but may include more center bosses. Similarly, the numbers of structures related to the cam operation and the elastic bodies may become larger or smaller. Furthermore, the structure, in which two holding parts are disposed in each of the arm parts and one holding pat is disposed in each of the support rings, has been exemplified as the structures of the holding parts according to an embodiment of the disclosure, but the numbers and the locations of the disposed holding parts may be adjusted. Accordingly, according to the foldable electronic device of the disclosure, modification of an additional structure or modification of the stabilizer may be considered based on a feature that the stabilizer (e.g., the ring shape, or a hook) is disposed on one side of the center bar such that the center bar positioned between the first rotary shaft and the second rotary shaft is moved upwards and downwards more stably in a process of folding or unfolding the foldable electronic device.

Each of the components (e.g., a module or a program) according to various embodiments may include a single or a plurality of entities, and some of the corresponding sub-components may be omitted or another subcomponent may be further included in various embodiments. Alternatively or additionally, some components (e.g., a module or a program) may be integrated into one entity to perform functions performed by the corresponding components before the integration in the same way or similarly. The operations performed by a module, a program module, or another component according to various embodiments may be executed sequentially, in parallel, repeatedly, or heuristically, or at least some operations may be executed in another sequence or may be omitted, or another operation may be added.

## Claims

1. A foldable electronic device comprising:
a first housing (110) and a second housing (120);
hinge structures (200a, 200b) connected to the first housing and the second housing; and
a display (160), at least a portion of which is disposed over the first housing, the hinge structures, and the second housing,
wherein the each hinge structure (200a, 200b) includes:
a first rotary shaft (231) configured to be rotated with respect to a first axis (11),
a second rotary shaft (232) configured to be rotated with respect to a second axis (12),
a first arm part (221) connected to the first rotary shaft;
a second arm part (222) connected to the second rotary shaft;
a first rotation part (211) connected to the first arm part and configured to be rotated with respect to a third axis;
a second rotation part (212) connected to the second arm part and configured to be rotated with respect to a fourth axis;
a center bar (270) disposed between the first rotary shaft and the second rotary shaft and disposed to face at least a portion of a rear surface of the display, wherein a fixing ring (1871) is formed on one side of the center bar (270) in a second direction that is opposite to a first direction that faces the display (160) and integrally formed with the center bar (270); and
a stabilizer (290) having a band or ring shape and configured to guide upward/downward movement of the center bar, wherein the one side of the stabilizer is coupled to the fixing ring.

2. The foldable electronic device of claim 1, wherein the one side of the stabilizer (290) is coupled to a hole formed in the fixing ring.

3. The foldable electronic device of claim 1, further comprising:
a ring connector (274) formed on one side of the center bar; and
wherein the fixing ring coupled to the ring connector.

4. The foldable electronic device of claim 3, wherein the ring connector includes:
a first ring connecting hole (274_1) passing through the center bar upwards and downwards; and
a second ring connecting hole (274_2) passing through the center bar upwards and downwards and disposed to be adjacent to the first ring connecting hole, and
wherein the fixing ring includes:
a first leg (281) coupled to the first ring connecting hole;
a second leg (282) coupled to the second ring connecting hole; and
a connecting ring connecting the first leg (281) and the second leg (282), and to which the one side of the stabilizer is coupled.

5. The foldable electronic device of claim 1, wherein the stabilizer includes:
a gap (290a) formed by widening a portion of the band or ring shape.

6. The foldable electronic device of claim 1, further comprising at least one of:
a center bracket (243a) coupled to the first rotary shaft and the second rotary shaft, and facing one side of the first arm part and one side of the second arm part; and
a shaft bracket (243b) coupled to the first rotary shaft and the second rotary shaft and facing an opposite side of the first arm part and an opposite side of the second arm part.

7. The foldable electronic device of claim 6, wherein the at least one of the center bracket or the shaft bracket includes:
a bracket body (212_1);
a first bracket wing part formed on one side of the bracket body and coupled to the first rotary shaft;
a second bracket wing part formed on opposite side of the bracket body and coupled to the second rotary shaft; and
a holding hole (243_3b1) formed in the bracket body and disposed between the first bracket wing part and the second bracket wing part.

8. The foldable electronic device of claim 7, further comprising:
a first holding member (301a) seated in the holding hole; and
a first elastic member (302a) coupled to the first holding member.

9. The foldable electronic device of claim 8, wherein the center bar further includes:
a first center boss (272a) formed in a second direction that is opposite to a first direction that faces the display, and
wherein at least a portion of the first holding member and the first elastic member is disposed on an inside of the first center boss.

10. The foldable electronic device of claim 9, wherein the first elastic member includes:
a spring inserted into the first center boss.

11. The foldable electronic device of claim 8, wherein the center bar further includes:
a first center boss (272a) formed in a second direction that is opposite to a first direction that faces the display, and
wherein the first center boss includes:
an empty space, into which a portion of the first holding member is inserted.

12. The foldable electronic device of claim 11, wherein the first elastic member includes:
at least one leaf spring disposed between an end of the center boss in the second direction and the first holding member.

13. The foldable electronic device of claim 1, further comprising:
a hinge housing, in which at least a portion of the hinge structures is seated, and
wherein the hinge housing includes:
a bar connector (1951) extending from a bottom surface of the hinge housing in a direction of the display; and
a bar connecting hole passing through the bar connector, and to which a portion of the stabilizer is coupled.

## Patentansprüche

1. Faltbare elektronische Vorrichtung, die Folgendes umfasst:
ein erstes Gehäuse (110) und ein zweites Gehäuse (120);
Scharnierstrukturen (200a, 200b), die mit dem ersten Gehäuse und dem zweiten Gehäuse verbunden sind; und
ein Display (160), von dem zumindest ein Teil über dem ersten Gehäuse, den Scharnierstrukturen und dem zweiten Gehäuse angeordnet ist,
wobei jede Scharnierstruktur (200a, 200b) Folgendes enthält:
eine erste Drehwelle (231), die so konfiguriert ist, dass sie in Bezug auf eine erste Achse (11) gedreht werden kann,
eine zweite Drehwelle (232), die so konfiguriert ist, dass sie in Bezug auf eine zweite Achse (12) gedreht werden kann,
ein erstes Armteil (221), das mit der ersten Drehwelle verbunden ist;
ein zweites Armteil (222), das mit der zweiten Drehwelle verbunden ist;
ein erstes Rotationsteil (211), das mit dem ersten Armteil verbunden ist und so konfiguriert ist, dass es in Bezug auf eine dritte Achse gedreht werden kann;
ein zweites Rotationsteil (212), das mit dem zweiten Armteil verbunden ist und so konfiguriert ist, dass es in Bezug auf eine vierte Achse gedreht werden kann;
eine Mittelstange (270), die zwischen der ersten Drehwelle und der zweiten Drehwelle angeordnet ist und so angeordnet ist, dass sie zumindest einem Teil einer Rückfläche des Displays zugewandt ist, wobei ein Befestigungsring (1871) auf einer Seite der Mittelstange (270) in einer zweiten Richtung gebildet ist, die einer ersten Richtung entgegengesetzt ist, die dem Display (160) zugewandt ist, und einstückig mit der Mittelstange (270) gebildet ist; und
einen Stabilisator (290), der eine Band- oder Ringform aufweist und so konfiguriert ist, dass er die Aufwärts-/Abwärtsbewegung der Mittelstange führt, wobei die eine Seite des Stabilisators mit dem Befestigungsring gekoppelt ist.

2. Faltbare elektronische Vorrichtung nach Anspruch 1, wobei die eine Seite des Stabilisators (290) mit einem Loch gekoppelt ist, das in dem Befestigungsring gebildet ist.

3. Faltbare elektronische Vorrichtung nach Anspruch 1, die ferner Folgendes umfasst:
einen Ringverbinder (274), der an einer Seite der Mittelstange gebildet ist; und
wobei der Befestigungsring mit dem Ringverbinder gekoppelt ist.

4. Faltbare elektronische Vorrichtung nach Anspruch 3, wobei der Ringverbinder Folgendes enthält:
ein erstes Ringverbindungsloch (274_1), das durch die Mittelstange nach oben und unten verläuft; und
ein zweites Ringverbindungsloch (274_2), das durch die Mittelstange nach oben und unten verläuft und so angeordnet ist, dass es neben dem ersten Ringverbindungsloch liegt, und
wobei der Befestigungsring Folgendes enthält:
ein erstes Bein (281), das mit dem ersten Ringverbindungsloch gekoppelt ist;
ein zweites Bein (282), das mit dem zweiten Ringverbindungsloch gekoppelt ist; und
einen Verbindungsring, der das erste Bein (281) und das zweite Bein (282) verbindet, und an den die eine Seite des Stabilisators gekoppelt ist.

5. Faltbare elektronische Vorrichtung nach Anspruch 1, wobei der Stabilisator Folgendes enthält:
einen Spalt (290a), der durch die Verbreiterung eines Teils des Bandes oder der Ringform gebildet wird.

6. Faltbare elektronische Vorrichtung nach Anspruch 1, die ferner mindestens eines von Folgendem umfasst:
eine Mittelhalterung (243a), die mit der ersten Drehwelle und der zweiten Drehwelle gekoppelt ist und einer Seite des ersten Armteils und einer Seite des zweiten Armteils zugewandt ist; und/oder
eine Wellenhalterung (243b), die mit der ersten Drehwelle und der zweiten Drehwelle gekoppelt ist und einer gegenüberliegenden Seite des ersten Armteils und einer gegenüberliegenden Seite des zweiten Armteils zugewandt ist.

7. Faltbare elektronische Vorrichtung nach Anspruch 6, wobei die Mittelhalterung und/oder die Wellenhalterung Folgendes enthält:
einen Halterungskörper (212_1);
ein erstes Halterungsflügelteil, das auf einer Seite des Halterungskörpers gebildet und mit der ersten Drehwelle gekoppelt ist;
ein zweites Halterungsflügelteil, das auf der gegenüberliegenden Seite des Halterungskörpers gebildet und mit der zweiten Drehwelle gekoppelt ist; und
ein Halteloch (243_3b1), das in dem Halterungskörper gebildet und zwischen dem ersten Halterungsflügelteil und dem zweiten Halterungsflügelteil angeordnet ist.

8. Faltbare elektronische Vorrichtung nach Anspruch 7, die ferner Folgendes umfasst:
ein erstes Halteelement (301a), das in dem Halteloch sitzt; und
ein erstes elastisches Element (302a), das mit dem ersten Halteelement gekoppelt ist.

9. Faltbare elektronische Vorrichtung nach Anspruch 8, wobei die Mittelstange ferner Folgendes umfasst:
einen ersten Mittelbuckel (272a), der in einer zweiten Richtung gebildet ist, die einer ersten Richtung, die dem Display zugewandt ist, entgegengesetzt ist, und
wobei zumindest ein Teil des ersten Halteelements und des ersten elastischen Elements auf einer Innenseite des ersten Mittelbuckels angeordnet ist.

10. Faltbare elektronische Vorrichtung nach Anspruch 9, wobei das erste elastische Element Folgendes enthält:
eine Feder, die in den ersten Mittelbuckel eingefügt ist.

11. Faltbare elektronische Vorrichtung nach Anspruch 8, wobei die Mittelstange ferner Folgendes enthält:
einen ersten Mittelbuckel (272a), der in einer zweiten Richtung gebildet ist, die einer ersten Richtung, die dem Display zugewandt ist, entgegengesetzt ist, und
wobei der erste Mittelbuckel Folgendes enthält:
einen leeren Raum, in den ein Teil des ersten Halteelements eingefügt ist.

12. Faltbare elektronische Vorrichtung nach Anspruch 11, wobei das erste elastische Element Folgendes enthält:
mindestens eine Blattfeder, die zwischen einem Ende des Mittelbuckels in der zweiten Richtung und dem ersten Halteelement angeordnet ist.

13. Faltbare elektronische Vorrichtung nach Anspruch 1, die ferner Folgendes umfasst:
ein Scharniergehäuse, in dem zumindest ein Teil der Scharnierstrukturen sitzt, und
wobei das Scharniergehäuse Folgendes enthält:
einen Stangenverbinder (1951), der sich von einer Unterseite des Scharniergehäuses in Richtung des Displays erstreckt; und
ein Stangenverbindungsloch, das durch den Stangenverbinder verläuft und an das ein Teil des Stabilisators gekoppelt ist.

## Revendications

1. Dispositif électronique pliable comprenant :
un premier boîtier (110) et un deuxième boîtier (120),
des structures de charnière (200a, 200b) connectées au premier boîtier et au deuxième boîtier ; et
un écran (160), dont au moins une portion est disposée sur le premier boîtier, les structures de charnière et le deuxième boîtier,
où chaque structure de charnière (200a, 200b) inclut :
un premier arbre rotatif (231) configuré pour être mis en rotation par rapport à un premier axe (11),
un deuxième arbre rotatif (232) configuré pour être mis en rotation par rapport à un deuxième axe (12),
une première partie de bras (221) connectée au premier arbre rotatif ;
une deuxième partie de bras (222) connectée au deuxième arbre rotatif ;
une première partie de rotation (211) connectée à la première partie de bras et configurée pour être mise en rotation par rapport à un troisième axe ;
une deuxième partie de rotation (212) connectée à la deuxième partie de bras et configurée pour être mise en rotation par rapport à un quatrième axe ;
une barre centrale (270) disposée entre le premier arbre rotatif et le deuxième arbre rotatif et disposée pour faire face à au moins une portion d'une surface arrière de l'écran, où une bague de fixation (1871) est formée sur un côté de la barre centrale (270) dans une deuxième direction qui est opposée à une première direction qui fait face à l'écran (160) et formée d'un seul tenant avec la barre centrale (270) ; et
un stabilisateur (290) ayant une forme de bande ou de bague et configuré pour guider le mouvement vers le haut/vers le bas de la barre centrale, où l'un des côtés du stabilisateur est couplé à la bague de fixation.

2. Dispositif électronique pliable selon la revendication 1, où l'un des côtés du stabilisateur (290) est couplé à un trou formé dans la bague de fixation.

3. Dispositif électronique pliable selon la revendication 1, comprenant en outre :
un connecteur annulaire (274) formé sur un côté de la barre centrale ; et
où la bague de fixation est couplée au connecteur annulaire.

4. Dispositif électronique pliable selon la revendication 3, où le connecteur annulaire inclut :
un premier trou de connexion annulaire (274_1) passant à travers la barre centrale vers le haut et vers le bas ; et
un deuxième trou de connexion annulaire (274_2) passant à travers la barre centrale vers le haut et vers le bas et disposé pour être adjacent au premier trou de connexion annulaire, et
où la bague de fixation inclut :
une première jambe (281) couplée au premier trou de connexion annulaire ;
une deuxième jambe (282) couplée au deuxième trou de connexion annulaire ; et
une bague de connexion connectant la première jambe (281) et la deuxième jambe (282), et à laquelle l'un des côtés du stabilisateur est couplé.

5. Dispositif électronique pliable selon la revendication 1, où le stabilisateur inclut :
un espace (290a) formé en élargissant une portion de la forme de bande ou de bague.

6. Dispositif électronique pliable selon la revendication 1, comprenant en outre au moins l'un parmi :
un support central (243a) couplé au premier arbre rotatif et au deuxième arbre rotatif, et faisant face à un côté de la première partie de bras et à un côté de la deuxième partie de bras ; et
un support d'arbre (243b) couplé au premier arbre rotatif et au deuxième arbre rotatif et faisant face à un côté opposé de la première partie de bras et à un côté opposé de la deuxième partie de bras.

7. Dispositif électronique pliable selon la revendication 6, où l'au moins un parmi le support central et le support d'arbre inclut :
un corps de support (212_1) ;
une première partie d'aile de support formée sur un côté du corps de support et couplée au premier arbre rotatif ;
une deuxième partie d'aile de support formée sur le côté opposé du corps de support et couplée au deuxième arbre rotatif ; et
un trou de maintien (243_3b1) formé dans le corps de support et disposé entre la première partie d'aile de support et la deuxième partie d'aile de support.

8. Dispositif électronique pliable selon la revendication 7, comprenant en outre :
un premier élément de maintien (301a) logé dans le trou de maintien ; et
un premier élément élastique (302a) couplé au premier élément de maintien.

9. Dispositif électronique pliable selon la revendication 8, où la barre centrale inclut en outre :
un premier bossage central (272a) formé dans une deuxième direction qui est opposée à une première direction qui fait face à l'écran, et
où au moins une portion du premier élément de maintien et du premier élément élastique est disposée à l'intérieur du premier bossage central.

10. Dispositif électronique pliable selon la revendication 9, où le premier élément élastique inclut :
un ressort inséré dans le premier bossage central,

11. Dispositif électronique pliable selon la revendication 8, où la barre centrale inclut en outre :
un premier bossage central (272a) formé dans une deuxième direction qui est opposée à une première direction qui fait face à l'écran, et
où le premier bossage central inclut :
un espace vide dans lequel une portion du premier élément de maintien est insérée.

12. Dispositif électronique pliable selon la revendication 11, où le premier élément élastique inclut :
au moins un ressort à lames disposé entre une extrémité du bossage central dans la deuxième direction et le premier élément de maintien.

13. Dispositif électronique pliable selon la revendication 1, comprenant en outre :
un boîtier de charnière dans lequel est logée au moins une portion des structures de charnière, et
où le boîtier de charnière inclut :
un connecteur de barre (1951) s'étendant à partir d'une surface inférieure du boîtier de charnière en direction de l'écran ; et
un trou de connexion de barre passant à travers le connecteur de barre, et auquel une portion du stabilisateur est couplée.
